# EUROPEAN PATENT APPLICATION

(11) **EP 4 669 081 A1**
(43) Date of publication of application: **24.12.2025**
(21) Application number: 23927909.4
(22) Date of filing: 17.03.2023
(51) Int. Cl.: H10K 59/60, H10K 50/842

(54) **DISPLAY PANEL AND DISPLAY APPARATUS**

(71) Applicant: Huawei Technologies Co., Ltd., Shenzhen, Guangdong 518129 (CN)
(72) Inventor: ZHOU, Xiaodong, Shenzhen, Guangdong 518129 (CN); HAN, Gangfeng, Shenzhen, Guangdong 518129 (CN); JIA, Longchang, Shenzhen, Guangdong 518129 (CN); LIU, Guohe, Shenzhen, Guangdong 518129 (CN); HUANG, Qiangcan, Shenzhen, Guangdong 518129 (CN)
(74) Representative: Pfenning, Meinig & Partner mbB
(86) International application number: PCT/CN2023/082329
(87) International publication number: WO 2024/192590

(57) **Abstract**

A display panel (100) and a display apparatus are disclosed. The display panel (100) includes a display region (AA), an opening region (BB), and a frame region (CC). The frame region (CC) is disposed around the opening region (BB) and is located between the display region (AA) and the opening region (BB). The display panel (100) includes a substrate (10), a driving thin film transistor (60), and a photosensitive component (40). The driving thin film transistor (60) is formed in the display region (AA), and is configured to drive a light emitting component (70) of the display panel (100). The photosensitive component (40) is formed in the frame region (CC), and is configured to detect ambient light. Both the photosensitive component (40) and the driving thin film transistor (60) are disposed on the substrate (10). According to the foregoing solution, the photosensitive component (40) may be integrated into the display panel (100), to reduce attenuation of light passing through the display panel (100), and improve a light sensing capability of the photosensitive component (40). The photosensitive component (40) is disposed in the frame region (CC) around the opening region (BB) of the display panel (100), so that a display area that is of the display panel (100) and that is occupied by the photosensitive component (40) can be reduced, and the display area is maximized.

## Description

### TECHNICAL FIELD

This application relates to the field of display technologies, and in particular, to a display panel and a display apparatus.

### BACKGROUND

A light sensing function is a necessary function of a current terminal product that has a display function. The light sensing function enables a terminal apparatus to sense changes in intensity, color temperature, and the like of ambient light, so as to guide an operating system of the terminal product to intelligently adjust a display effect of a display panel accordingly.

The light sensing function is implemented by a photosensitive component. In the current terminal product, an independent photosensitive element, for example, a photosensitive diode, is used. Because the photosensitive component is an independent photosensitive element, a corresponding position needs to be reserved in the component, resulting in some limitations in design of the terminal product. For example, disposing the photosensitive component on a frame of the terminal product reduces an effective display area of the terminal product. Alternatively, disposing the photosensitive component below the display panel reduces a light sensing capability of the photosensitive component.

### SUMMARY

In view of this, this application provides a display panel, to increase an effective display area of the display panel and improve a light sensing capability of a photosensitive component.

According to a first aspect, this application provides a display panel. The display panel includes a display region, an opening region, and a frame region. The frame region is disposed around the opening region and is located between the display region and the opening region. The display panel includes a substrate, a driving thin film transistor, and a photosensitive component. The driving thin film transistor is formed in the display region, and the driving thin film transistor is configured to drive a light emitting component layer of the display panel. The photosensitive component is formed in the frame region, and the photosensitive component is configured to detect ambient light. Both the photosensitive component and the driving thin film transistor are disposed on the substrate.

It may be understood that both the photosensitive component and the driving thin film transistor are disposed on the substrate of the display panel. In other words, the photosensitive component is integrated into the display panel, so that attenuation of light passing through the display panel can be reduced, and a light sensing capability of the photosensitive component is improved. Disposing the photosensitive component in the frame region around the opening region of the display panel can reduce a display area that is of the display panel and that is occupied by the photosensitive component, so that the display area is maximized.

With reference to the first aspect, in a possible implementation, the display panel further includes a buffer layer, and the buffer layer is formed on the substrate. The driving thin film transistor includes a first semiconductor layer and a source/drain layer. The first semiconductor layer is formed on the buffer layer, and the source/drain layer is formed on a side that is of the first semiconductor layer and that is away from the substrate. The photosensitive unit includes a second semiconductor layer and a first electrode layer. The second semiconductor layer is formed on the buffer layer, and the first electrode layer is formed on a side that is of the second semiconductor layer and that is away from the substrate.

In this implementation, the second semiconductor layer of the photosensitive component and the first semiconductor layer of the driving thin film transistor are implemented using a same process step, and the first electrode layer of the photosensitive component and the source/drain layer of the driving thin film transistor are implemented using a same process step. In this way, the photosensitive component can be synchronously completed in a manufacturing process of the display panel, so that the photosensitive component is integrated into the display panel in a manufacturing process of the display panel.

With reference to the first aspect, in a possible implementation, the display panel further includes a top conductive layer. The top conductive layer is formed on a side that is of the first electrode layer and the source/drain layer and that is away from the substrate. The top conductive layer is used for tracing of the first electrode layer and the source/drain layer.

In this implementation, the photosensitive component is traced through a tracing layer on the top of the driving thin film transistor, so that the photosensitive component can be connected to a driver chip without adding an additional process step.

With reference to the first aspect, in a possible implementation, the display panel further includes a bottom conductive layer. The bottom conductive layer is formed on a side that is of the first semiconductor layer and the second semiconductor layer and that is close to the substrate. The bottom conductive layer is used for tracing of the first electrode layer.

In this implementation, the photosensitive component is traced through a film layer that is on the bottom of the driving thin film transistor and that is used for light shielding, so that the photosensitive component can be connected to the driver chip without adding an additional process step.

With reference to the first aspect, in a possible implementation, the display panel includes scanning lines and data lines that are vertically disposed in a cross manner. At least a part of scanning lines are disconnected at a same column of pixel units in a direction perpendicular to the scanning lines. Disconnection points of several scanning lines jointly form a tracing channel. A trace of the photosensitive unit passes through the tracing channel and is connected from the frame region to an end part of the display panel.

In this implementation, disconnecting the scanning lines in double-sided tracing from the middle can provide a channel for the trace of the photosensitive component, so that interference between a signal transmitted by the photosensitive component and a drive signal of the display panel can be greatly reduced.

With reference to the first aspect, in a possible implementation, the photosensitive component includes at least two photosensitive modules, and the at least two photosensitive modules are disposed around the opening region.

With reference to the first aspect, in a possible implementation, the at least two photosensitive modules are of a sector ring structure. Photosensitive modules of the sector ring structure are connected end to end, and jointly form a circular ring structure through enclosing.

With reference to the first aspect, in a possible implementation, each photosensitive module is of a circular ring structure. The at least two photosensitive modules are nested.

With reference to the first aspect, in a possible implementation, the display panel includes a barrier wall and an isolation pillar. The barrier wall and the isolation pillar are formed on the substrate. The barrier wall includes a first barrier wall. The isolation pillar includes an inner isolation pillar and a middle isolation pillar, and the inner isolation pillar is located on a side that is of the first barrier wall and that is close to the display region. The middle isolation pillar is located on a side that is of the first barrier wall and that is close to the opening region. The photosensitive component is disposed between the first barrier wall and the inner isolation pillar, or the photosensitive component is disposed between the first barrier wall and the middle isolation pillar. With reference to the first aspect, in a possible implementation, the barrier wall further includes a second barrier wall. The isolation pillar further includes an outer isolation pillar. The second barrier wall is located on a side that is of the middle isolation pillar and that is close to the opening region. The outer isolation pillar is located on a side that is of the second barrier wall and that is close to the opening region. The photosensitive component is disposed between the first barrier wall and the inner isolation pillar, or the photosensitive component is disposed between the first barrier wall and the middle isolation pillar, or the photosensitive component is disposed between the second barrier wall and the middle isolation pillar.

In this implementation, disposing the second barrier wall and the outer isolation pillar can better isolate external water and oxygen, and retain extension of a crack caused by an opening.

With reference to the first aspect, in a possible implementation, the photosensitive component includes at least two photosensitive modules, each photosensitive module is of a circular ring structure, the at least two photosensitive modules are nested, and one of the at least two photosensitive modules is disposed below the first barrier wall.

With reference to the first aspect, in a possible implementation, the display panel includes a first inorganic layer, an organic layer, and a second inorganic layer. The first inorganic layer is formed in the display region and the frame region, and the first inorganic layer covers the driving thin film transistor and a photosensitive unit. The organic layer is formed in the display region and at least a part of the frame region. The second inorganic layer is formed in the display region and the frame region, and the second inorganic layer is formed on a surface of the first inorganic layer or the organic layer.

With reference to the first aspect, in a possible implementation, the display panel further includes an amplification unit. The amplification unit is connected to the photosensitive component, and is configured to amplify a signal measured by the photosensitive component.

According to a second aspect, this application further provides a display panel. The display panel includes a display region and two opening regions. The display panel includes a substrate, a driving thin film transistor, and a photosensitive component. The driving thin film transistor is formed in the display region, and the driving thin film transistor is configured to drive a light emitting component of the display panel. The photosensitive component is formed between the two opening regions, and the photosensitive component is configured to detect ambient light. Both the photosensitive component and the driving thin film transistor are disposed on the substrate.

According to a third aspect, this application further provides a display apparatus. The display apparatus includes a display panel and a drive circuit. The drive circuit is configured to: drive the display panel to perform display, provide a working voltage for the photosensitive component, and receive a signal transmitted by the photosensitive component.

The display panel includes a display region, an opening region, and a frame region. The frame region is disposed around the opening region and is located between the display region and the opening region. The display panel includes a substrate, a driving thin film transistor, and a photosensitive component. The driving thin film transistor is formed in the display region. The photosensitive component is formed in the frame region, and the photosensitive component is configured to detect ambient light. The photosensitive component includes a photosensitive unit and a light filtering unit, and both the photosensitive unit and the driving thin film transistor are disposed above the substrate.

Alternatively, the display panel includes a display region and two opening regions. The display panel includes a substrate, a driving thin film transistor, and a photosensitive component. The driving thin film transistor is formed in the display region, and the driving thin film transistor is configured to drive a light emitting component of the display panel. The photosensitive component is formed between the two opening regions, and the photosensitive component is configured to detect ambient light. Both the photosensitive component and the driving thin film transistor are disposed on the substrate.

In addition, for technical effects of the second aspect and the third aspect, refer to technical effects brought by different implementations of the first aspect. Details are not described herein again.

### BRIEF DESCRIPTION OF DRAWINGS

FIG. 1 is a diagram of a structure of a display panel according to an embodiment of this application;
FIG. 2 is a cross-sectional view of the display panel in FIG. 1 in a V-V' direction;
FIG. 3A is a diagram of structures of a photosensitive unit and a driving thin film transistor in FIG. 2;
FIG. 3B is another diagram of structures of a photosensitive unit and a driving thin film transistor in FIG. 2;
FIG. 3C is another diagram of structures of a photosensitive unit and a driving thin film transistor in FIG. 2;
FIG. 3D is a diagram of an amplification unit, a photosensitive unit, and a driving thin film transistor according to an embodiment of this application;
FIG. 4A is a top view of a photosensitive unit in FIG. 2;
FIG. 4B is a cross-sectional view of the photosensitive unit in FIG. 4A in a VI-VI' direction;
FIG. 5A is a diagram of tracing between a photosensitive component and a driver chip according to an embodiment of this application;
FIG. 5B is another diagram of tracing between a photosensitive component and a driver chip according to an embodiment of this application;
FIG. 5C is another diagram of tracing between a photosensitive component and a driver chip according to an embodiment of this application;
FIG. 6A is a diagram in which a photosensitive component passes through a display region of a display panel according to an embodiment of this application;
FIG. 6B is another diagram in which a photosensitive component passes through a display region of a display panel according to an embodiment of this application;
FIG. 7A is a diagram of a photosensitive component according to an embodiment of this application;
FIG. 7B is a diagram of a photosensitive unit of the photosensitive component in FIG. 7A;
FIG. 8A is another diagram of a photosensitive component according to an embodiment of this application;
FIG. 8B is another diagram of a photosensitive component according to an embodiment of this application;
FIG. 8C is a cross-sectional view of a photosensitive unit in FIG. 8A in a VII-VII' direction;
FIG. 8D is another diagram of a photosensitive component according to an embodiment of this application;
FIG. 8E is another diagram of a photosensitive component according to an embodiment of this application;
FIG. 8F is another diagram of a photosensitive component according to an embodiment of this application;
FIG. 9A is another diagram of a photosensitive component according to an embodiment of this application;
FIG. 9B is a diagram of a photosensitive unit of the photosensitive component in FIG. 9A;
FIG. 10A is another diagram of a photosensitive component according to an embodiment of this application;
FIG. 10B is a diagram of a photosensitive unit of the photosensitive component in FIG. 10A;
FIG. 11 is a diagram of structures of a photosensitive component and a first barrier wall in FIG. 2;
FIG. 12A is a diagram of a photosensitive unit in FIG. 11;
FIG. 12B is a cross-sectional view of the photosensitive unit in FIG. 12A in an IX-IX' direction;
FIG. 13A is another diagram of a photosensitive unit in FIG. 11;
FIG. 13B is a cross-sectional view of the photosensitive unit in FIG. 13A in an X-X' direction;
FIG. 14A is another diagram of a photosensitive unit in FIG. 11;
FIG. 14B is a cross-sectional view of the photosensitive unit in FIG. 14A in an XI-XI' direction;
FIG. 14C is a cross-sectional view of the photosensitive unit in FIG. 14A in an XII-XII' direction;
FIG. 15A is another diagram of a photosensitive component according to an embodiment of this application;
FIG. 15B is a cross-sectional view of the photosensitive component in FIG. 15A in a VIII-VIII' direction;
FIG. 15C is another diagram of a photosensitive component according to an embodiment of this application;
FIG. 15D is another diagram of a photosensitive component according to an embodiment of this application;
FIG. 16 is another diagram of a structure of a display panel according to an embodiment of this application; and
FIG. 17 is a diagram of a display apparatus according to an embodiment of this application.

### DESCRIPTION OF EMBODIMENTS

The following clearly and completely describes the technical solutions in embodiments of this application with reference to the accompanying drawings in embodiments of this application.

A term "and/or" in this specification describes only an association relationship between associated objects and indicates that there may be three relationships. For example, A and/or B may represent the following three cases: Only A exists, both A and B exist, and only B exists.

In descriptions of this application, the terms "first", "second", and the like are merely intended to distinguish between different objects, but do not limit a quantity or an execution sequence, and the terms "first", "second", and the like do not indicate a definite difference either. In addition, terms such as "include" and "have" and any other variants thereof are intended to cover a non-exclusive inclusion.

An independent photosensitive element is used as a photosensitive component in a current display apparatus. The photosensitive component is disposed on a frame on one side of the display apparatus, or is disposed below a display panel. Disposing the photosensitive component on the frame of the display apparatus makes the frame of the display apparatus need to be widened. Even to keep a width of the frame around the display apparatus as the same as possible, the frame around the display apparatus needs to be widened at the same time. In this case, an effective display area of the display apparatus is greatly reduced. Disposing the photosensitive component below the display panel reduces ambient light irradiated to the photosensitive component. In this case, the photosensitive element needs stronger light to implement a better photosensitive effect. In other words, disposing the photosensitive component below the display panel reduces a light sensing capability of the photosensitive component.

To resolve the foregoing technical problem, an embodiment of this application provides a display panel. According to the display panel provided in this embodiment of this application, a photosensitive component may be integrated into the display panel.

The display panel provided in this embodiment of this application includes a display region, an opening region, and a frame region. The frame region is disposed around the opening region and is located between the display region and the opening region. The display panel includes a substrate, a driving thin film transistor, and a photosensitive component. The driving thin film transistor is formed in the display region. The photosensitive component is formed in the frame region, and the photosensitive component is configured to detect ambient light. The photosensitive component includes a photosensitive unit and a light filtering unit. Both the photosensitive unit and the driving thin film transistor are disposed above the substrate.

In this embodiment of this application, both the photosensitive unit and the driving thin film transistor are disposed above the substrate of the display panel, so that attenuation of light passing through the display panel can be reduced, and a light sensing capability of the photosensitive component is improved. Disposing the photosensitive unit in the frame region around the opening region of the display panel can reduce a display area of the display panel used by the photosensitive component, so that the display area is maximized.

To make a person skilled in the art understand the solutions in this application better, the following clearly and completely describes the technical solutions in embodiments of this application with reference to the accompanying drawings in embodiments of this application.

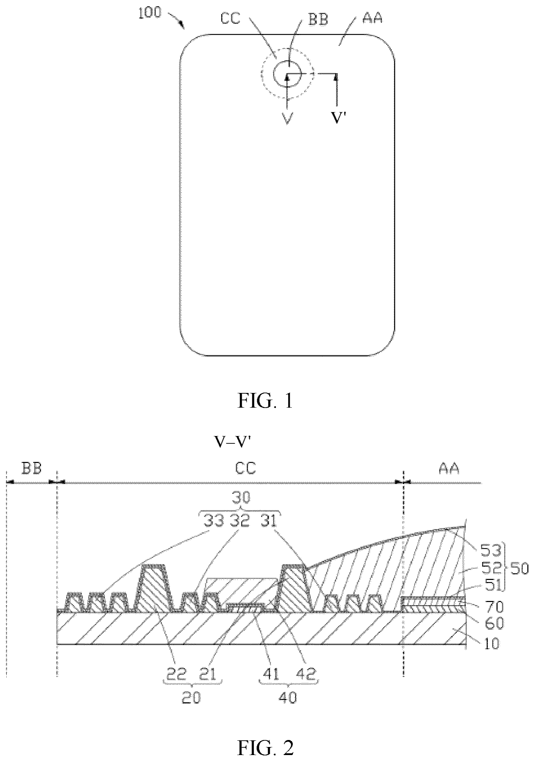

FIG. 1 is a diagram of a display panel 100 according to an embodiment of this application. The display panel 100 includes a display region AA, an opening region BB, and a frame region CC located between the display region AA and the opening region BB.

It may be understood that shapes of the opening region BB and the frame region CC are not limited in embodiments of this application. For example, the opening region BB is circular. Correspondingly, a shape of the frame region CC is a ring around the opening region BB.

FIG. 2 is a diagram of a cross-sectional structure of the display panel 100 in FIG. 1 in a V-V' direction. The display panel 100 includes a substrate 10. The substrate 10 is disposed in the display region AA and the frame region CC. A barrier wall 20, an isolation pillar 30, and a photosensitive component 40 are further disposed in the frame region CC.

The substrate 10 may be made of a flexible organic material, for example, polyimide (polyimide, PI) or another material having a similar feature.

The barrier wall 20 is formed on the substrate 10, and the barrier wall 20 is configured to retain extension of a crack caused by an opening. The isolation pillar 30 is formed on the substrate 10, and the isolation pillar 30 is configured to isolate external water and oxygen. For example, a height of the barrier wall 20 is higher than that of the isolation pillar 30.

It may be understood that a quantity of barrier walls 20 and a quantity of isolation pillars 30 are not limited in embodiments of this application.

In an embodiment, the barrier wall 20 includes at least a first barrier wall 21, and the isolation pillar includes at least an inner isolation pillar 31 and a middle isolation pillar 32. The inner isolation pillar 31 is located on a side that is of the first barrier wall 21 and that is close to the display region AA. The middle isolation pillar 32 is located on a side that is of the first barrier wall 21 and that is close to the opening region BB. In this embodiment, the photosensitive component 40 is disposed between the first barrier wall 21 and the inner isolation pillar 31, or the photosensitive component 40 is disposed between the first barrier wall 21 and the middle isolation pillar 32.

In an embodiment, in addition to the first barrier wall 21, the barrier wall 20 further includes a second barrier wall 22. In addition to the inner isolation pillar 31 and the middle isolation pillar 32, the isolation pillar 30 further includes an outer isolation pillar 33. The second barrier wall 22 is located on a side that is of the middle isolation pillar 32 and that is close to the opening region BB. The outer isolation pillar 33 is located on a side that is of the second barrier wall 22 and that is close to the opening region BB. In this embodiment, the photosensitive component 40 is disposed between the first barrier wall 21 and the inner isolation pillar 31, or the photosensitive component 40 is disposed between the first barrier wall 21 and the middle isolation pillar 32. Alternatively, the photosensitive component 40 is disposed between the second barrier wall 22 and the middle isolation pillar 32. It may be understood that disposing the second barrier wall 22 and the outer isolation pillar 31 can better isolate external water and oxygen, and retain extension of a crack caused by an opening.

For example, as shown in FIG. 2, the photosensitive component 40 is disposed between the first barrier wall 21 and the middle isolation pillar 32.

The photosensitive component 40 is configured to detect ambient light. The photosensitive component 40 includes a photosensitive unit 41 and a light filtering unit 42. The light filtering unit 42 is disposed above the photosensitive unit 41. The light filtering unit 42 is configured to filter out a part of ambient light. The photosensitive unit 41 is configured to measure intensity of light that is correspondingly transmitted through the light filtering unit 42. It may be understood that the intensity of the light can be used to calculate a color temperature of the ambient light.

In this embodiment of this application, the display region AA includes a driving thin film transistor 60 and a light emitting component layer 70. The light emitting component layer 70 includes a plurality of light emitting units, and the light emitting unit is an organic light emitting diode (Organic Light Emitting Diode, OLED) unit. The light emitting unit is configured to emit light under driving of the driving thin film transistor 60.

In this embodiment of this application, a thin film encapsulation (Thin Film Encapsulation, TFE) layer 50 is disposed in the display region AA and the frame region CC. The thin film encapsulation layer 50 includes a first inorganic layer 51, an organic layer 52, and a second inorganic layer 53.

The first inorganic layer 51 extends from the display region AA to the opening region BB. The first inorganic layer 51 sequentially covers the light emitting component layer 70 in the display region AA, and the inner isolation pillar 31, the first barrier wall 21, the middle isolation pillar 32, the second barrier wall 22, and the outer isolation pillar 33 that are in the frame region CC. The organic layer 52 extends from the display region AA to the opening region BB, and covers at least a part of the first inorganic layer 51. For example, the organic layer 52 covers the light emitting component layer 70 and the inner isolation pillar 31 that are in the frame region CC. The organic layer 52 covers the first inorganic layer 51. The second inorganic layer 53 extends from the display region AA to the opening region BB, and sequentially covers the organic layer 52 and the first inorganic layer 51. Sealed space is enclosed, on the side that is of the first barrier wall 21 and that is close to the display region AA, by the first inorganic layer 51 and the second inorganic layer 53. The organic layer 52 is disposed in the sealed space.

It may be understood that a deposition manner of the thin film encapsulation layer 50 is not limited in embodiments of this application. In a possible implementation, chemical vapor deposition (Chemical Vapor Deposition, CVD) is used as a deposition manner of the first inorganic layer 51 and the second inorganic layer 52, to isolate water and oxygen. A deposition manner of the organic layer 52 is mainly ink jet printing (Ink Jet Printing, IJP).

In this embodiment of this application, the display panel 100 includes a substrate 10 and a buffer (Buffer) layer, and the buffer layer is formed on the substrate 10. The driving thin film transistor 60 and the photosensitive unit 41 of the photosensitive component 40 are formed on the buffer layer. The driving thin film transistor 60 includes a first semiconductor layer and a source/drain layer. The source/drain layer is formed on a side that is of the first semiconductor layer and that is away from the substrate. The photosensitive unit 41 includes a second semiconductor layer and a first electrode layer. The first electrode layer is formed on a side that is of the second semiconductor layer and that is away from the substrate.

In an embodiment, the first semiconductor layer and the second semiconductor layer are formed in a same process step, and the source/drain layer and the first electrode layer are formed in a same process step.

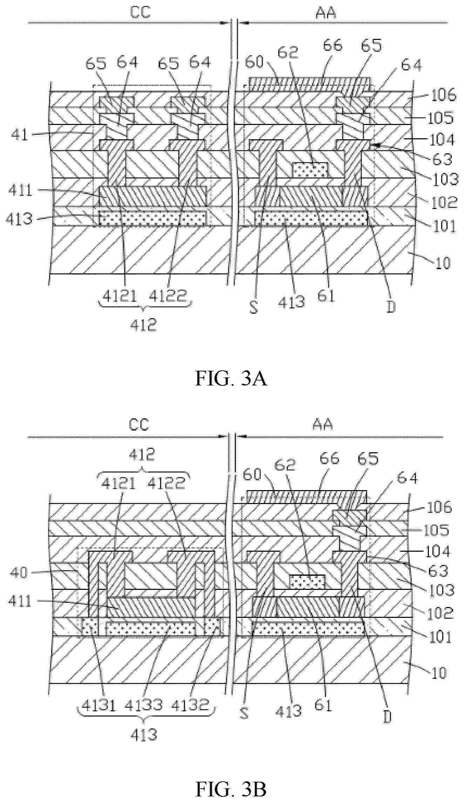

For example, FIG. 3A is a diagram of the photosensitive unit 41 and the driving thin film transistor 60 in FIG. 2.

The display panel 100 includes a buffer layer 101 formed on the substrate 10. The driving thin film transistor 60 and the photosensitive unit 41 are formed on the buffer layer 101. The driving thin film transistor 60 is located in the display region AA. The photosensitive unit 41 is formed in the frame region CC. In other words, the substrate 10 and the buffer layer 101 are in both the display region AA and the frame region CC.

The display panel 100 further includes a gate insulation layer (Gate Insulation Layer, GI) 102, an interlayer dielectric layer (Interlayer Dielectric Layer, ILD) 103, and a source/drain insulation layer 104 that are disposed on a side that is of the buffer layer 101 and that is away from the substrate 10. The gate insulation layer 102 may be made of silicon oxide or another insulation material. The gate layer 62 is made of a conductive material, for example, a metal material. A material of the source/drain insulation layer 104 may be, for example, laminated silicon oxide and silicon nitride, or another feasible material.

For example, the driving thin film transistor 60 includes a first semiconductor layer 61, the gate insulation layer 102, the gate layer 62, the interlayer dielectric layer 103, the source/drain insulation layer 104, and a source/drain layer 63. The first semiconductor layer 61 is formed on the buffer layer 101. The first semiconductor layer 61 may be used as an active region of the driving thin film transistor 60. The gate insulation layer 102 is formed on the buffer layer 101 and the first semiconductor layer 61. The gate insulation layer 102 covers the first semiconductor layer 61. The gate layer 62 is formed on the gate insulation layer 102. The interlayer dielectric layer 103 is formed on the gate insulation layer 102 and the gate layer 62. The interlayer dielectric layer 103 covers the gate layer 62. The source/drain insulation layer 104 is formed on the interlayer dielectric layer 103. The source/drain layer 63 is formed on the interlayer dielectric layer 103. The source/drain layer 63 includes a source S of the driving thin film transistor 60 and a drain D of the driving thin film transistor 60. The source S and the drain D are electrically connected to the first semiconductor layer 61 through a corresponding conductive through hole separately. The conductive through hole between the source/drain layer 63 and the first semiconductor layer 61 penetrates the interlayer dielectric layer 103 and the gate insulation layer 102.

For example, the photosensitive unit 41 includes a second semiconductor layer 411, the gate insulation layer 102, the interlayer dielectric layer 103, the first electrode layer 412, and the source/drain insulation layer 104. The second semiconductor layer 411 is formed on the buffer layer 101. The second semiconductor layer 411 may be used as an active region of the photosensitive unit 41. The gate insulation layer 102 is formed on the buffer layer 101 and the second semiconductor layer 411. The gate insulation layer 102 covers the second semiconductor layer 411. The interlayer dielectric layer 103 is formed on the gate insulation layer 102. The source/drain insulation layer 104 is formed on the interlayer dielectric layer 103. The first electrode layer 412 is formed on the interlayer dielectric layer 103. The first electrode layer 412 includes a first electrode 4121 and a second electrode 4122 that are of the photosensitive unit 41. The first electrode 4121 and the second electrode 4122 are electrically connected to the second semiconductor layer 411 through a corresponding conductive through hole separately. The conductive through hole between the first electrode layer 412 and the second semiconductor layer 411 penetrates the interlayer dielectric layer 103 and the gate insulation layer 102.

It may be understood that the second semiconductor layer 411 and the first semiconductor layer 61 are both formed on the buffer layer 101. Therefore, the second semiconductor layer 411 and the first semiconductor layer 61 can be implemented using a same process step. For example, the second semiconductor layer 411 and the first semiconductor layer 61 are deposited on the buffer layer 101 in a same process, and are formed at required positions by using a patterning technology. The first electrode layer 412 and the source/drain layer 63 are both formed on the interlayer dielectric layer 103. Therefore, the first electrode layer 412 and the source/drain layer 631 can be implemented using a same process step. For example, the first electrode layer 412 and the source/drain layer 63 are deposited on the interlayer dielectric layer 103 in a same process, and are formed at required positions by using a patterning technology.

It may be understood that, in this embodiment of this application, the second semiconductor layer 411 of the photosensitive component 40 and the first semiconductor layer 61 of the driving thin film transistor 60 are implemented using a same process step, and the first electrode layer 412 of the photosensitive component 40 and the source/drain layer 63 of the driving thin film transistor 60 are implemented using a same process step, so that the photosensitive component 40 can be synchronously manufactured in a manufacturing process of the display panel 100. In other words, the photosensitive component 40 is integrated into the display panel 100 in the manufacturing process of the display panel 100.

In an implementation, the display panel 100 further includes a top conductive layer. The top conductive layer is formed on a side that is of the first electrode layer 412 and that is away from the substrate 10. The top conductive layer is used for tracing of the source/drain layer 631 of the driving thin film transistor 60 and the first electrode layer 412 of the photosensitive unit 41.

For example, as shown in FIG. 3A, the display panel 100 further includes a first top conductive layer 64. A first passivation layer (PVX) 105 is further formed on the source/drain insulation layer 104. Specifically, the first top conductive layer 64 is formed on the source/drain insulation layer 104. The first top conductive layer 64 is electrically connected to the source/drain layer 63 through a corresponding conductive through hole. The first top conductive layer 64 is further electrically connected to the first electrode layer 412 through a corresponding conductive through hole. Both the conductive through hole between the first top conductive layer 64 and the source/drain layer 63 and the conductive through hole between the first top conductive layer 64 and the first electrode layer 412 penetrate the source/drain insulation layer 104. The first passivation layer 105 is formed on the source/drain insulation layer 104 and the first top conductive layer 64. The first passivation layer 105 covers the first top conductive layer 64.

Further, the display panel 100 may further include a second top conductive layer 65. A second passivation layer 106 is further formed on the source/drain insulation layer 104. Specifically, the second top conductive layer 65 is electrically connected to the first top conductive layer 64 through a corresponding conductive through hole. The conductive through hole between the second top conductive layer 65 and the first top conductive layer 64 penetrates the first passivation layer 105. The second passivation layer 106 covers the second top conductive layer 65.

In this implementation, the first electrode 4121 and the second electrode 4122 can be connected to a driver chip through at least one of the first top conductive layer 64 and the second top conductive layer 65.

It may be understood that in the display panel 100, tracing of the photosensitive component 40 is performed through a tracing layer (namely, the first top conductive layer or the second top conductive layer) on the top of the driving thin film transistor 60, so that the photosensitive component 40 can be connected to the driver chip without adding an additional process step.

In a possible case, the display panel 100 may further include a bottom conductive layer 413. The bottom conductive layer 413 is formed below the first semiconductor layer 61 and the second semiconductor layer 411, for example, formed at the buffer layer 101. The bottom conductive layer 413 is configured to shield the first semiconductor layer 61 and the second semiconductor layer 411 from light. It may be understood that a film layer for light shielding is disposed below the first semiconductor layer 61, to prevent light from affecting a driving effect of the driving thin film transistor 60. The film layer for light shielding is disposed below the second semiconductor layer 411 to prevent interference light other than ambient light from being irradiated to the second semiconductor layer 411 to form a photocurrent, thereby affecting light detection of the photosensitive unit 41.

FIG. 3B is another diagram of the photosensitive unit 41 and the driving thin film transistor 60 in FIG. 2.

It may be understood that structures of the driving thin film transistor 60 and the photosensitive unit 41 in FIG. 3B are basically similar to those in FIG. 3A. Details are not described herein again.

In an implementation, the display panel 100 includes the bottom conductive layer 413. The bottom conductive layer 413 is disposed below the second semiconductor layer 411, for example, disposed at the buffer layer 101. The first electrode layer 412 is electrically connected to the bottom conductive layer 413 through a corresponding conductive through hole. The conductive through hole between the first electrode layer 412 and the bottom conductive layer 413 penetrates the interlayer dielectric layer 103 and the gate insulation layer 102.

The bottom conductive layer 413 includes a first trace 4131, a second trace 4132, and a third trace 4133 that are not connected to each other. The first trace 4131 is electrically connected to the first electrode 4121, and the second trace 4132 is electrically connected to the second electrode 4122. It may be understood that one of the first trace 4131 and the second trace 4132 is a signal line, and the other is a ground line. For example, the first trace 4131 is a ground line, and the second trace 4132 is a signal line. The third trace 4133 is configured to shield the first semiconductor layer 61 and the second semiconductor layer 411 from light. It may be understood that disposing the third trace 4133 can reduce interference of light to the driving thin film transistor 60 and the photosensitive unit 41.

In this implementation, the first electrode 4121 and the second electrode 4122 can be connected to the driver chip through the bottom conductive layer 413.

It may be understood that in the display panel 100, tracing of the photosensitive component 40 is performed through the film layer for light shielding (namely, the bottom conductive layer 413) on the bottom of the driving thin film transistor 60, so that the photosensitive component 40 can be connected to the driver chip without adding an additional process step.

In an embodiment, the first semiconductor layer and the second semiconductor layer may not be formed in a same process step, and the source/drain layer and the first electrode layer may not be formed in a same process step.

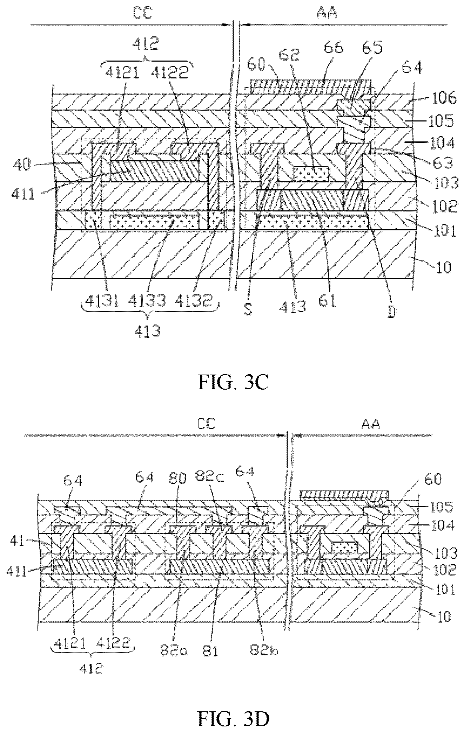

For example, FIG. 3C is another diagram of the photosensitive unit 41 and the driving thin film transistor 60 in FIG. 2.

It may be understood that a structure of the driving thin film transistor 60 in FIG. 3C is basically similar to a structure of the driving thin film transistor 60 in FIG. 3A. Details are not described herein again.

Same parts of the photosensitive unit 41 in FIG. 3C and the photosensitive unit 41 in FIG. 3A are not described again. A difference lies only in that the second semiconductor layer 411 of the photosensitive unit 41 in FIG. 3C is formed on the gate insulation layer 102 instead of the buffer layer 101.

In a possible implementation, the display panel 100 further includes an amplification unit 80. The amplification unit 80 is electrically connected to the photosensitive unit 41, and is configured to amplify an amount of signal sensed by the photosensitive unit 41. For example, the amplification unit 80 is configured to amplify an amount of a voltage signal or a current signal measured by the photosensitive unit 41. The amplification unit 80 and the photosensitive unit 41 are disposed at a same layer. For example, FIG. 3D is a diagram of the amplification unit 80 and the photosensitive unit 41 according to an embodiment of this application.

The amplification unit 80 includes a third semiconductor layer 81 and a second electrode layer 82. The third semiconductor layer 81 and the second semiconductor layer 411 are disposed at a same layer, that is, both are disposed on the buffer layer 101. The second electrode layer 82 and the first electrode layer 412 are disposed at a same layer, that is, both are disposed on the interlayer dielectric layer 103. In other words, the third semiconductor layer 81 and the second semiconductor layer 411 are formed in a same process step, and the second electrode layer 82 and the first electrode layer 412 are formed in a same process step.

The second electrode layer 82 includes a first end 82a, a second end 82b, and a third end 82c that are of the amplification unit 41. The first end 82a is configured to connect to a positive voltage VDD (a connection relationship is not shown in the figure). The second end 82b is configured to connect to a negative voltage VSS (a connection relationship is not shown in the figure). The third end is configured to connect to one of the first electrode 4121 and the second electrode 4122 of the photosensitive unit 41, for example, to the second electrode 4122. For example, the amplification unit 41 is a PNP or NPN transistor, where the first end 82a is a collector, the second end is an emitter, and the third end is a base.

It may be understood that, in some other implementations, the third semiconductor layer 81 and the second semiconductor layer 411 may alternatively not be formed in a same process step. Alternatively, the second electrode layer 82 and the first electrode layer 412 may not be formed in a same process step.

It may be understood that an anti-interference capability of the photosensitive unit 41 can be improved by disposing the amplification unit 80 to amplify a signal obtained by the photosensitive unit 41.

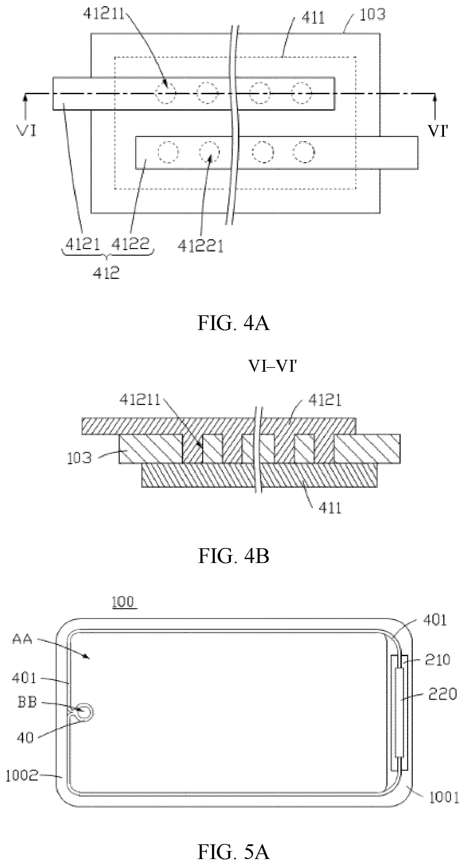

Refer to FIG. 4A and FIG. 4B together. FIG. 4A is a top view of the photosensitive unit 41 in FIG. 2. FIG. 4B is a sectional view in a VI-VI' direction in FIG. 4A.

The first electrode layer 412 is formed on the interlayer dielectric layer 103. In a possible implementation, both the first electrode 4121 and the second electrode 4122 are formed on the interlayer dielectric layer 103 in a strip shape. The first electrode 4121 is electrically connected to the second semiconductor layer 411 through several first conductive through holes 41211. The second electrode 4122 is electrically connected to the second semiconductor layer 411 through several second conductive through holes 41221. The several first conductive through holes 41211 are provided on the first electrode 4121 in an array shape, and the several second conductive through holes 41221 are provided on the second electrode 4122 in an array shape.

The first electrode 4121 and the second electrode 4122 are spaced away from each other. When no light is irradiated on the second semiconductor layer 411, the second semiconductor layer 411 is in an insulated state. Therefore, the first electrode 4121 is not connected to the second electrode 4122. When light of the ambient light is irradiated on the second semiconductor layer 411, the second semiconductor layer 411 changes from the insulation state to a conductor state, and a photocurrent is formed between the first electrode 4121 and the second electrode 4122. In this way, the first electrode 4121 is connected to the second electrode 4122. A voltage signal and a current signal between the first electrode 4121 and the second electrode 4122 are transmitted to the driver chip through traces that are connected to the first electrode 4121 and the second electrode 4122.

In this embodiment of this application, the photosensitive component 40 includes several photosensitive modules, and each photosensitive module is configured to implement different functions of detecting light in the ambient light. For example, some photosensitive modules are configured to detect one of red light, green light, or blue light in the ambient light. Some photosensitive modules are configured to detect intensity of light in the ambient light. Some photosensitive modules are configured to detect ultraviolet or infrared rays.

In an embodiment, the photosensitive component 40 includes a photosensitive module RD (Red) configured to detect the red light, a photosensitive module GN (Green) configured to detect the green light, a photosensitive module BU (Blue) configured to detect the blue light, a photosensitive module WH (White) configured to detect the white light, and a photosensitive module BK (Black) configured to provide a reference signal.

Each photosensitive module includes a corresponding photosensitive unit 41 and a light filtering unit 42. The light filtering unit 42 is configured to filter a part or all of the ambient light irradiated to the photosensitive unit 41. Specifically, the light filtering unit 42 of the photosensitive module RD is configured to: transmit the red light, and filter light other than the red light in the ambient light irradiated to the photosensitive unit 41. The light filtering unit 42 of the photosensitive module GN is configured to transmit the green light, and filter light other than the green light in ambient light irradiated to the photosensitive unit 41. The light filtering unit 42 of the photosensitive module BU is configured to transmit the blue light, and filter light other than the blue light in the ambient light irradiated to the photosensitive unit 41. The light filtering unit 42 of the photosensitive module WH is configured to transmit the white light without filtering any ambient light irradiated to the photosensitive unit 41. The light filtering unit of the photosensitive module BK is configured to filter all light, that is, absorb all the light, so that no light is irradiated to the photosensitive unit 41.

In a possible implementation, each photosensitive module (RD, GN, BU, WH, and BK) is connected to one signal line, and the five photosensitive modules are jointly connected to one ground line. In other words, in this embodiment, the photosensitive component 40 includes five signal lines and one ground line. The photosensitive unit 41 in each photosensitive module can detect a voltage or current signal between the first electrode 4121 and the second electrode 4122, and transmit the voltage or current signal to the driver chip through a corresponding signal line.

In this embodiment of this application, the photosensitive component 40 is disposed around the opening region BB. The photosensitive component 40 is connected to the driver chip through a trace. A position at which the driver chip is disposed is not limited herein. For example, a non-display region disposed at an end part, namely, a bottom end or a top end, of the display panel 100. The top end is an end that is of the display panel 100 and that is close to the opening region BB, and the bottom end is an end that is of the display panel 100 and that is away from the opening region BB.

It may be understood that the photosensitive component 40 can be led out from the frame region CC and connected to the driver chip through a trace of the first top conductive layer 64, the second top conductive layer 65, or the bottom conductive layer 413.

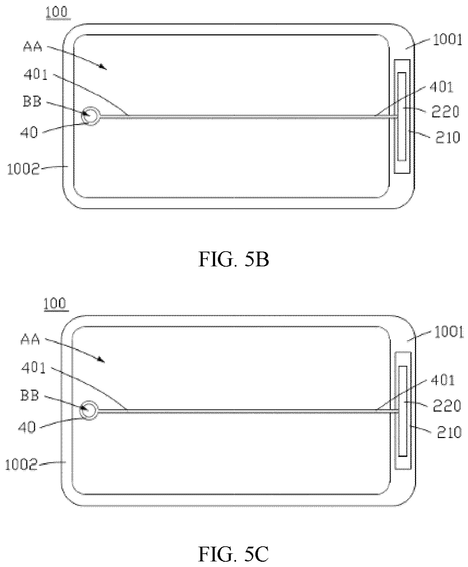

Refer to FIG. 5A, FIG. 5B, and FIG. 5C. FIG. 5A is a diagram of tracing between the photosensitive component 40 and the driver chip 220 according to an embodiment of this application.

As shown in FIG. 5A, in an embodiment, a circuit board 210 is disposed at a bottom end 1001. For example, the circuit board 210 disposed in a fanout (Fanout) region at the bottom end 1001. The driver chip 220 is disposed on the circuit board 210. The photosensitive component 40 is connected to the driver chip 220 through a trace 401. The trace 401 is led out from a side that is of a display unit 41 and that is close to the top end 1002 to the non-display region at the top end 1002, and then is led out from non-display regions on left and right sides of the display panel 100 to the driver chip 220 at the bottom end 1001.

FIG. 5B is another diagram of tracing between the photosensitive component 40 and the driver chip according to an embodiment of this application.

As shown in FIG. 5B, in an embodiment, the circuit board 210 is disposed at the bottom end 1001. For example, the circuit board 210 is disposed in a fanout region at the bottom end 1001. The driver chip 220 is disposed on the circuit board 210. The photosensitive component 40 is connected to the driver chip 220 through a trace 401. The trace 401 is directly led out from a side that is of the display unit 41 and that is away from the top end 1002 to the fanout region at the bottom end 1001, and is connected to the driver chip 220 at the bottom end 1001.

FIG. 5C is another diagram of tracing between the photosensitive component 40 and the driver chip according to an embodiment of this application.

As shown in FIG. 5C, in an embodiment, the circuit board 210 is disposed at the top end 1002. The driver chip 220 is disposed on the circuit board 210. The photosensitive component 40 is connected to the driver chip 220 through a trace 401. The trace 401 is led out from a side that is of the display unit 41 and that is close to the top end 1002 to a non-display region at the top end 1002, and is connected to the driver chip 220 at the top end 1002.

It should be understood that positions of the circuit board 210 and the driver chip 220 shown in FIG. 5A to FIG. 5C are both schematic. In an actual product, there may be a bent part at an end part of the display panel 100, that is, the bottom end 1001 or the top end 1002 of the display panel 100, and the driver chip 220 is disposed on the bent part.

In this embodiment of this application, in a process of being led out from the frame region CC to the non-display region at the top end 1002 or the non-display region at the bottom end 1001, the trace 401 needs to pass through a part of the display region AA.

In this embodiment of this application, the display region AA of the display panel 100 includes scanning lines and data lines that are vertically disposed in a cross manner. A signal line and a ground line of each photosensitive module are traced around the frame region CC, are centralized to a preset position, and then pass through the display region AA. It may be understood that the scanning lines and the data lines are drive structures of the display panel 100. For example, the scanning lines are disposed horizontally, and the data lines are disposed vertically.

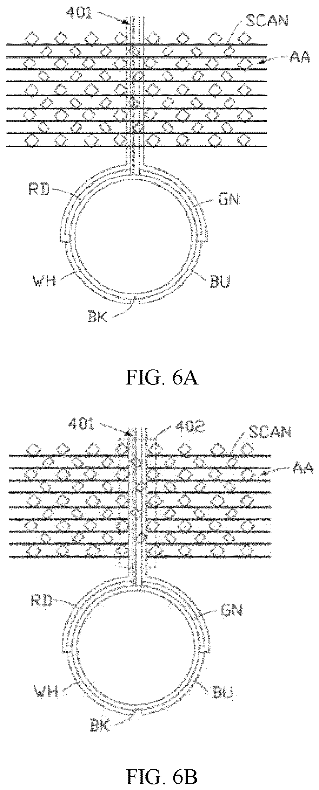

FIG. 6A is a diagram in which a trace of the photosensitive component 40 passes through the display region AA according to an embodiment of this application.

For example, signal lines and ground lines of the five photosensitive modules (RD, GN, BU, WH, and BK) are traced around the frame region CC, are centralized to a same preset position, and then enter the display region AA from the preset position.

In a possible implementation, trace parts that are of the five photosensitive modules and that are located in the display region AA are centralized in a same column of pixels. It may be understood that centralizing traces in a small region, for example, centralizing the traces in a same column of pixel units, can reduce signal interference, thereby reducing impact on performance of the display panel 100.

In an implementation, signal lines and ground lines of the five photosensitive modules may be traced through one or two of the first top conductive layer 64 and the second top conductive layer 65 (refer to FIG. 3A), to transmit an optical signal to the driver chip. In another implementation, signal lines and ground lines of the five photosensitive modules may be traced through the bottom conductive layer 413 (refer to FIG. 3B), to transmit an optical signal to the driver chip.

With reference to FIG. 6B, FIG. 6A is another diagram in which a trace of the photosensitive component 40 passes through the display region AA according to an embodiment of this application.

In an embodiment, at least a part of scanning lines are disconnected at a same column of pixel units in a direction perpendicular to the scanning lines. Disconnection points of several scanning lines jointly form a tracing channel. A trace of each photosensitive module passes through the tracing channel and is connected from a frame region to a non-display region at an end part of the display panel 100.

For example, scanning lines between the photosensitive component 40 and a fanout region of the display panel 100 are disconnected at a same column of pixel units in a direction perpendicular to the scanning lines SCAN of the display panel 100. The disconnection points of the several scanning lines SCAN jointly form a tracing channel 402. The trace 401 of the photosensitive component 40 passes through the tracing channel and is connected to the bottom end or the top end of the display panel 100 from the frame region CC.

It may be understood that, disconnecting the scanning lines SCAN in double-sided tracing from the middle can provide a channel for the trace of the photosensitive component 40, so that interference between a signal transmitted by the photosensitive component 40 and a drive signal of the display panel 100 can be greatly reduced.

In a possible implementation, a load capacitor is disposed in a non-display region at the bottom end or the top end of the display panel 100. The trace 401 is connected to the driver chip through the load capacitor. It may be understood that signal interference can be reduced by disposing the load capacitor at the position of the trace 401.

In this embodiment of this application, the photosensitive component 40 includes at least two photosensitive modules. The at least two photosensitive modules are disposed around the opening region BB. It may be understood that a specific quantity of photosensitive modules of the photosensitive component 40 may be set as required. This is not limited in embodiments of this application. For example, there may be two, four, five, or more photosensitive modules.

In an embodiment, the photosensitive component 40 includes at least two photosensitive modules. The at least two photosensitive modules are of a sector ring structure. Photosensitive modules of the sector ring structure are connected end to end, and jointly form a circular ring structure through enclosing.

In an implementation, the photosensitive component 40 includes at least two photosensitive modules. One of the at least two photosensitive modules is of a circular ring structure. Another photosensitive module in the at least two photosensitive modules is of a sector ring structure. The photosensitive modules of the sector ring structure are connected end to end, and jointly form a circular ring structure through enclosing.

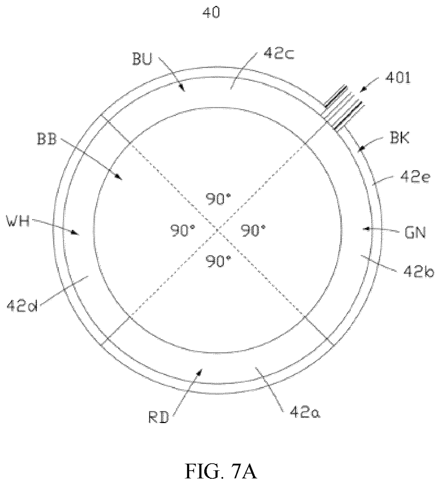

For example, FIG. 7A is a diagram of the photosensitive component 40 according to an embodiment of this application. The photosensitive component 40 includes the five photosensitive modules: the photosensitive module RD, the photosensitive module GN, the photosensitive module BU, the photosensitive module WH, and the photosensitive module BK.

The four photosensitive modules (RD, GN, BU, and WH) each are of a sector ring structure. The four photosensitive modules of the sector ring structure are connected end to end around the opening region BB, and jointly form a first circular ring structure through enclosing. The photosensitive module BK is of a second circular ring structure. The second circular ring structure is disposed on an outer edge of the first circular ring structure. In other words, the first circular ring structure enclosed by the four photosensitive modules of the sector ring structure is nested in the second circular ring structure formed by the photosensitive module BK.

Further, the four photosensitive modules of the sector ring structure are equally disposed. In other words, a center angle of each sector ring structure is approximately at 90 degrees.

In this implementation, relative positions between the second circular ring structure formed by the photosensitive module BK and the first circular ring structure formed by the four sector ring structures are not limited. It may be understood that, in another possible case, the second circular ring structure may alternatively be disposed on an inner edge of the first circular ring structure. In other words, the second circular ring structure formed by the photosensitive module BK may alternatively be nested in the first circular ring structure formed by the four optical modules of a sector structure.

It may be understood that an arrangement sequence of the four photosensitive modules of the sector ring structure is not limited herein. For example, the fourth photosensitive modules of the sector ring structure are sequentially disposed in a sequence of "RD, WH, BU, and GN" in a circumferential direction.

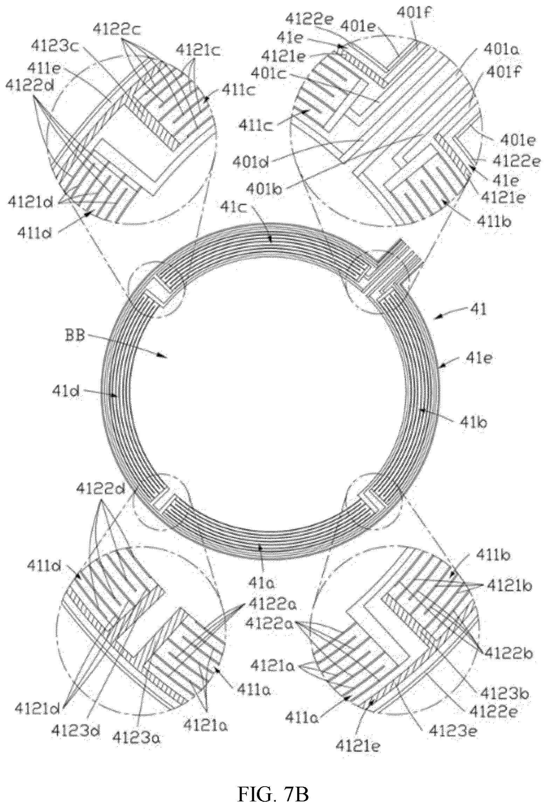

FIG. 7B is a diagram of a photosensitive unit of the photosensitive component 40 in FIG. 7A.

Each photosensitive module includes one photosensitive unit and one light filtering unit. Specifically, the photosensitive module RD includes a photosensitive unit 41a and a light filtering unit 42a (refer to FIG. 7A). The photosensitive module GN includes a photosensitive unit 41b and a light filtering unit 42b (refer to FIG. 7A). The photosensitive module BU includes a photosensitive unit 41 and a light filtering unit 42c (refer to FIG. 7A). The photosensitive module WH includes a photosensitive unit 41d and a light filtering unit 42d (refer to FIG. 7A). The photosensitive module BK includes a photosensitive unit 41e and a light filtering unit 42e (refer to FIG. 7A). The light filtering unit 42a is configured to transmit red light, the light filtering unit 42b is configured to transmit green light, the light filtering unit 42c is configured to transmit blue light, the light filtering unit 42d is configured to transmit white light, and the light filtering unit 42e is configured to absorb all light. It may be understood that the light filtering unit 42e is also referred to as a black matrix. The light filtering unit 42e can absorb light, to prevent the light from being irradiated to the photosensitive unit 41e below the light filtering unit 42e.

Because the photosensitive unit is located below the corresponding light filtering unit, that is, the photosensitive unit is covered by the light filtering unit, shapes and position distribution of the photosensitive unit and the light filtering unit are consistent with those of the photosensitive component 40. In other words, four photosensitive modules (41a, 41b, 41c, and 41d) in the five photosensitive units each are of a sector ring structure. The photosensitive unit 41e is of a circular ring structure. The four photosensitive units of the sector ring structure are sequentially disposed, and are spaced from each other around edges of the opening region BB, and are not in contact with each other. The four photosensitive units of the sector ring structure are combined together to form an approximately circular ring structure. The photosensitive unit 41e is disposed around an outer edge of a circular ring formed by the four photosensitive units of the sector ring structure. In other words, a circular ring formed by the four photosensitive units of the sector ring structure is nested in the photosensitive unit 41e. The photosensitive unit 41e and the circular ring formed by the four photosensitive units of the sector ring structure are spaced from each other, and are not in contact with each other. In this way, the five photosensitive units (41a, 41b, 41c, 41d, and 41e) are spaced from each other, and are not in contact with each other.

It may be understood that the five photosensitive units are spaced from each other, so that no signal interference is generated between the five photosensitive modules. For example, a case in which light passing through a light filtering unit corresponding to one photosensitive module is irradiated to a photosensitive unit corresponding to another photosensitive module does not occur.

In this embodiment of this application, each photosensitive unit includes at least one pair of electrodes, that is, includes at least one first electrode and at least one second electrode. The first electrode is not in contact with the second electrode, so that ambient light can be irradiated to a second semiconductor layer of the photosensitive unit through a spacing between the first electrode and the second electrode.

For example, as shown in FIG. 7B, the photosensitive unit 41a includes a first electrode 4121a and a second electrode 4122a, the photosensitive unit 41b includes a first electrode 4121b and a second electrode 4122b, the photosensitive unit 41c includes a first electrode 4121c and a second electrode 4122c, the photosensitive unit 41d includes a first electrode 4121d and a second electrode 4122d, and the photosensitive unit 41e includes a first electrode 4121e and a second electrode 4122e.

In this embodiment, the first electrode 4121e of the photosensitive unit 41e includes a main body part and four extension parts. The main body part is disposed along an inner edge of the photosensitive unit e. One end of each of the four extension parts is connected to the main body part, and the other end of each extension part is connected to a first electrode of a photosensitive unit other than the photosensitive unit 41e.

For example, the first electrode 4121e includes a main body part 4123e, a first extension part 4123a, a second extension part 4123b, a third extension part 4123c, and a fourth extension part 4123d. The main body part 4123e is disposed along an inner edge of the photosensitive unit 41e. One end of the first extension part 4123a is connected to the main body part 4123e, and the other end of the first extension part 4123a extends inward, that is, extends in a center direction (the same below), and is connected to the first electrode 4121a of the photosensitive unit 41a. One end of the second extension part 4123b is connected to the main body part 4123e, and the other end of the second extension part 4123b extends inward and is connected to the first electrode 4121b of the photosensitive unit 41b. One end of the third extension part 4123c is connected to the main body part 4123e, and the other end of the third extension part 4123c extends inward and is connected to the first electrode 4121c of the photosensitive unit 41c. One end of the second extension part 4123d is connected to the main body part 4123e, and the other end of the second extension part 4123d extends inward and is connected to the first electrode 4121d of the photosensitive unit 41d.

For example, the four photosensitive units of the sector ring structure each include a plurality of first electrodes and a plurality of second electrodes that are disposed in a cross manner, and the first electrode and the second electrode that are adjacent to each other are spaced from each other.

In this embodiment, the trace 401 is disposed between the photosensitive component 40 and the driver chip 220. It may be understood that one end of the trace 401 is connected to the first electrode layer 412 (refer to FIG. 3A and FIG. 3B) of the photosensitive unit 41 of the photosensitive component 40, and the other end of the trace 401 is connected to the driver chip 220 (refer to FIG. 5A to FIG. 5C). It may be understood that one end of the trace 401 is connected to the first electrode layer 412, that is, connected to the first electrode and the second electrode of each photosensitive unit 41.

In this embodiment, the trace 401 includes five signal lines and one common electrode line. The common electrode line is configured to connect one of the first electrode and the second electrode of each photosensitive unit, and the five signal lines are configured to connect the other one of the first electrode and the second electrode of each photosensitive unit.

For example, the trace 401 includes a first signal line 401a, a second signal line 401b, a third signal line 401c, a fourth signal line 401d, a fifth signal line 401e, and a common electrode line 401f. The common electrode line 401f is a negative trace, and the other five signal lines are positive traces. A first electrode of a photosensitive unit 411 corresponding to each photosensitive module is connected to the common electrode line 401f. Specifically, the common electrode line 401f is connected to the first electrode 4121e of the photosensitive unit 41e. The four extension parts of the first electrode 4121e are respectively connected to the first electrodes (4121a, 4121b, 4121c, and 4121d) of the four photosensitive units of the sector ring structure. Therefore, the common electrode line 401f can be connected to the first electrode of the photosensitive unit corresponding to each photosensitive module. That is, the first electrode 4121 of the photosensitive unit 411a of the photosensitive module RD, the first electrode 4121 of the photosensitive unit 411b of the photosensitive module GN, the first electrode 4121 of the photosensitive unit 411c of the photosensitive module BU, the first electrode 4121 of the photosensitive unit 411d of the photosensitive module WH, and the first electrode 4121 of the photosensitive unit 411e of the photosensitive module BK are separately connected to the common electrode line 401f.

For example, the first signal line 401a is connected to the second electrode 4122a, the second signal line 401b is connected to the second electrode 4122b, the third signal line 401c is connected to the second electrode 4122c, the fourth signal line 401d is connected to the second electrode 4122d, and the fifth signal line 401e is connected to the second electrode 4122e.

In this embodiment of this application, after ambient light passes through the light filtering unit corresponding to the photosensitive module, remaining light is irradiated to a corresponding photosensitive unit. Under irradiation of light, a photocurrent is formed between the first electrode and the second electrode. The signal line and the common electrode line of each photosensitive module transmit a current or voltage signal generated between the first electrode and the second electrode to the driver chip 220.

For example, the common electrode line 401f is connected to the first electrode 4121 of the photosensitive module RD, and the first signal line 401a is connected to the second electrode 4122 of the photosensitive module RD. After ambient light passes through the light filtering unit 42a, remaining red light is irradiated to a polycrystalline silicon semiconductor layer 411a of the photosensitive unit 41a. The polycrystalline silicon semiconductor layer 411a changes from an insulation state to a conductor state under irradiation of red light, so that a photocurrent is formed between the first electrode 4121 and the second electrode 4122. In this way, a loop is formed among the common electrode line 401f, the first electrode 4121e, the first electrode 4121a, the second semiconductor layer 411a, the second electrode 4122a, the first signal line 401a, and the driver chip 220. A current or voltage signal generated between the first electrode 4121a and the second electrode 4122a is transmitted to the driver chip 220 through the common electrode line 401f and the first signal line 401a. It may be understood that working principles of the photosensitive module GN, the photosensitive module BU, and the photosensitive module WH are similar to those of the photosensitive module RD. Details are not described herein again.

For another example, the common electrode line 401f is connected to the first electrode 4121e of the photosensitive module BK, and the fifth signal line 401e is connected to the second electrode 4122e of the photosensitive module BK. When ambient light passes through the light filtering unit 42e, all light is absorbed by the light filtering unit 42e. Because the second semiconductor layer 411e is not irradiated by light, and is always in an insulation state, the first electrode 4121e and the second electrode 4122e are not connected to each other, and a photocurrent cannot be generated. A voltage or current signal transmitted by the common electrode line 401f and the fifth signal line 401e to the driver chip 220 is always 0. In other words, the driver chip 220 cannot detect a current or voltage signal between the first electrode 4121e and the second electrode 4122e of the photosensitive module BK.

It may be understood that the three photosensitive modules (R, G, and B) are configured to separately measure intensity of red light, green light, and blue light in the ambient light. A color temperature of light in the ambient light can be calculated based on intensity of the light of the three colors. The photosensitive module WH is configured to measure intensity of white light in the ambient light. The photosensitive module BK is configured to provide a reference value of light intensity.

It may be understood that, in some other implementations, the common electrode line 401f is a positive trace, and the first signal line 401a, the second signal line 401b, the third signal line 401c, the fourth signal line 401d, and the fifth signal line 401e are negative traces.

In an implementation, the photosensitive component 40 includes at least two photosensitive modules. All photosensitive modules each are of a sector ring structure. Photosensitive modules of the sector ring structure are connected end to end, and jointly form a circular ring structure through enclosing.

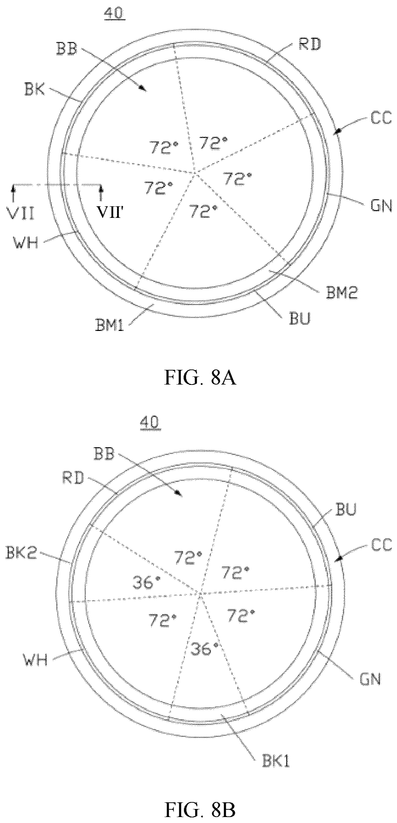

For example, FIG. 8A is another diagram of the photosensitive component 40 according to an embodiment of this application. The photosensitive component 40 includes five photosensitive modules: the photosensitive module RD, the photosensitive module GN, the photosensitive module BU, the photosensitive module WH, and the photosensitive module BK. The five photosensitive modules each are of a sector ring structure. The five photosensitive modules of the sector ring structure are connected end to end, and jointly form a circular ring structure through enclosing.

Further, the five photosensitive modules of the sector ring structure are equally disposed. In other words, a center angle of each sector ring structure is approximately at 72 degrees.

It may be understood that an arrangement sequence of the five photosensitive modules is not limited herein. For example, the five photosensitive modules are sequentially disposed in a sequence of "RD, GN, BU, WH, and BK" in a circumferential direction.

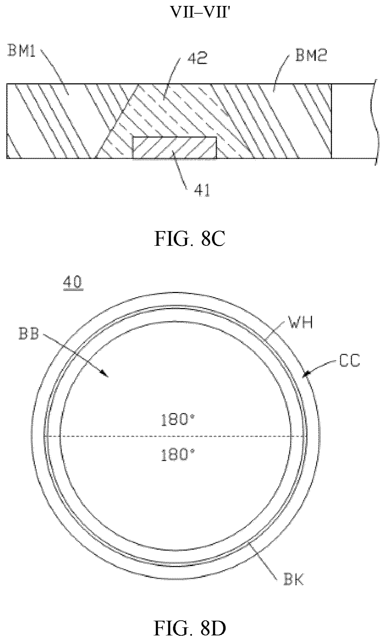

In a possible implementation, black matrices are disposed on both sides of the photosensitive module. For example, FIG. 8C is a sectional view of the photosensitive component 40 shown in FIG. 8A in a VII-VII' direction. A black matrix BM1 in a ring shape is disposed on an outer side of the circular ring structure formed by the five sector ring structures. A black matrix BM2 in a ring shape is disposed on an inner side of the circular ring structure.

As shown in FIG. 8C, the light filtering unit 42 is disposed above the photosensitive unit 41, and the light filtering unit 42 covers the photosensitive unit 41. The two black matrices (BM1 and BM2) are respectively disposed on two sides of the light filtering unit 42.

For another example, FIG. 8B is another diagram of the photosensitive component 40 according to an embodiment of this application. The photosensitive component 40 includes six photosensitive modules: a photosensitive module RD, a photosensitive module GN, a photosensitive module BU, a photosensitive module WH, a photosensitive module BK1, and a photosensitive module BK2. The six photosensitive modules each are of a sector ring structure. The six photosensitive modules of the sector ring structure are connected end to end, and jointly form a circular ring structure through enclosing.

Further, center angles of four photosensitive modules (RD, GN, BU, and WH) in the six photosensitive modules are approximately at 72 degrees. Center angles of two photosensitive modules (BK1 and BK2) in the six photosensitive modules are approximately at 36 degrees.

It may be understood that an arrangement sequence of the six photosensitive modules is not limited herein. For example, the six photosensitive modules are sequentially disposed in a sequence of "RD, BU, GN, BK1, WH, and BK2" in a circumferential direction.

FIG. 8D is another diagram of the photosensitive component 40 according to an embodiment of this application. The photosensitive component 40 includes two photosensitive modules: the photosensitive module WH and the photosensitive module BK. The two photosensitive modules each are of a sector ring structure. The two photosensitive modules of the sector ring structure are connected end to end, and jointly form a circular ring structure through enclosing.

Further, the two photosensitive modules are equally disposed. In other words, a center angle of each photosensitive module is approximately at 180 degrees.

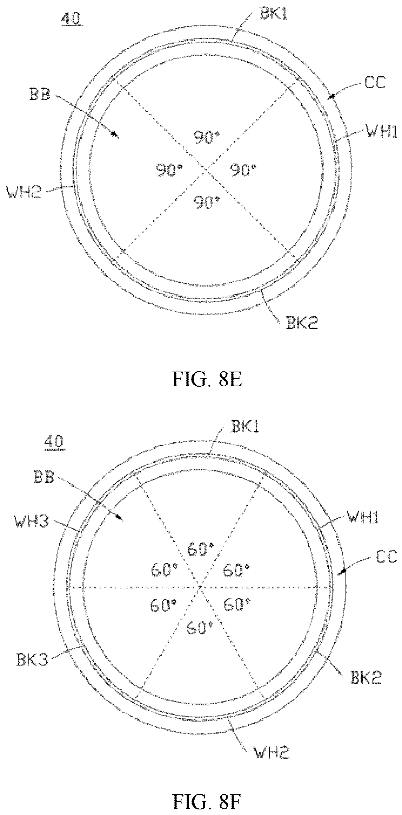

FIG. 8E is another diagram of the photosensitive component 40 according to an embodiment of this application. The photosensitive component 40 includes four photosensitive modules: the photosensitive module WH1, the photosensitive module BK1, the photosensitive module WH2, and the photosensitive module BK2. The four photosensitive modules each are of a sector ring structure. The four photosensitive modules of the sector ring structure are connected end to end, and jointly form a circular ring structure through enclosing.

Further, the four photosensitive modules are equally disposed. In other words, a center angle of each photosensitive module is approximately at 90 degrees.

In a possible case, two types of photosensitive modules are spaced away from each other. For example, the four photosensitive modules are sequentially disposed in a sequence of "WH1, BK1, WH2, and BK2" in a circumferential direction.

FIG. 8F is another diagram of the photosensitive component 40 according to an embodiment of this application. The photosensitive component 40 includes six photosensitive modules: the photosensitive module WH1, the photosensitive module WH2, the photosensitive module WH3, the photosensitive module BK1, the photosensitive module BK2, and a photosensitive module BK3. The six photosensitive modules each are of a sector ring structure. The six photosensitive modules of the sector ring structure are connected end to end, and jointly form a circular ring structure through enclosing.

Further, the six photosensitive modules are equally disposed. In other words, a center angle of each photosensitive module is approximately at 60 degrees.

In a possible case, two types of photosensitive modules are spaced away from each other. For example, the six photosensitive modules are sequentially disposed in a sequence of "WH1, BK1, WH2, BK2, WH3, and BK3" in a circumferential direction.

In an embodiment, the photosensitive component 40 includes at least two photosensitive modules. The photosensitive modules each are of a circular ring structure. The photosensitive modules are nested with each other.

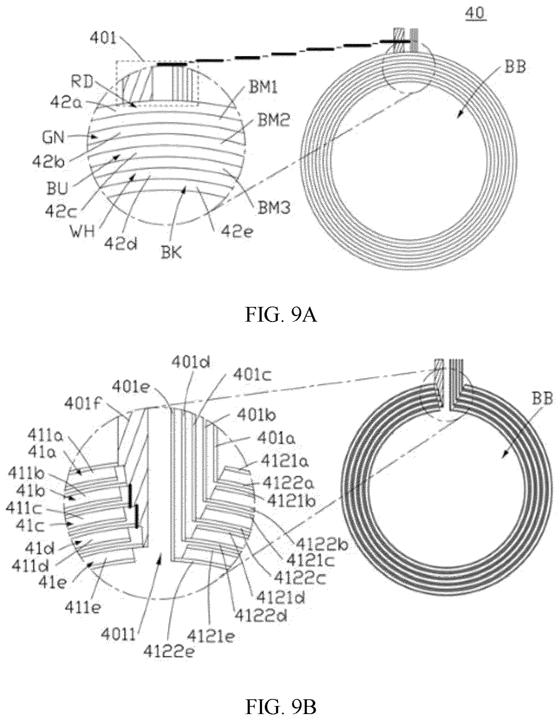

For example, FIG. 9A is another diagram of the photosensitive component 40 according to an embodiment of this application.

The photosensitive component 40 includes five photosensitive modules: the photosensitive module RD, the photosensitive module GN, the photosensitive module BU, the photosensitive module WH, and the photosensitive module BK. The five photosensitive modules each are of a circular ring structure. The five photosensitive modules are nested with each other.

It may be understood that an arrangement sequence of the five photosensitive modules is not limited herein. For example, the five photosensitive modules are sequentially disposed in a sequence of "RD, GN, BU, WH, and BK" from outside to inside in a radius direction of the circular ring structure.

In a possible implementation, a black matrix is further disposed between two adjacent photosensitive units. For example, a black matrix BM1 is disposed between the photosensitive unit RD and the photosensitive unit GN, a black matrix BM2 is disposed between the photosensitive unit GN and the photosensitive unit BU, and a black matrix BM3 is disposed between the photosensitive unit BU and the photosensitive unit WH. It may be understood that, because the light filtering unit 42e of the photosensitive unit BK is made of a same material, no black matrix needs to be disposed between the photosensitive unit BK and the photosensitive unit WH.

FIG. 9B is a diagram of a photosensitive unit of the photosensitive component 40 in FIG. 9A.

Each photosensitive module (RD, GN, BU, WH, and BK) includes one photosensitive unit (41a, 41b, 41c, 41d, and 41e) and one light filtering unit. (42a, 42b, 42c, 42d, and 42e). Shapes and position distribution of the photosensitive units and the light filtering units are approximately the same as the shape and position distribution of the photosensitive component 40. The five photosensitive units of the circular ring structure are sequentially nested, are spaced away from each other around the opening region BB, and are not in contact with each other.

In this embodiment of this application, each photosensitive unit includes a pair of electrodes, that is, includes one first electrode and one second electrode. The first electrode is not in contact with the second electrode, so that ambient light can be irradiated to a second semiconductor layer of the photosensitive unit through a spacing between the first electrode and the second electrode.

For example, as shown in FIG. 9B, the photosensitive unit 41a includes a first electrode 4121a and a second electrode 4122a, the photosensitive unit 41b includes a first electrode 4121b and a second electrode 4122b, the photosensitive unit 41c includes a first electrode 4121c and a second electrode 4122c, the photosensitive unit 41d includes a first electrode 4121d and a second electrode 4122d, and the photosensitive unit 41e includes a first electrode 4121e and a second electrode 4122e.

In this embodiment, the trace 401 includes five signal lines and one common electrode line. The common electrode line is configured to connect one of the first electrode and the second electrode of each photosensitive unit, and the five signal lines are configured to connect the other one of the first electrode and the second electrode of each photosensitive unit.

For example, the trace 401 includes a first signal line 401a, a second signal line 401b, a third signal line 401c, a fourth signal line 401d, a fifth signal line 401e, and a common electrode line 401f. The common electrode line 401f is a negative trace, and the other five signal lines are positive traces. It may be understood that a correspondence between the trace 401 and both the first electrode and the second electrode and a working principle of the photosensitive component 40 are similar to those in the embodiments described in FIG. 7A and FIG. 7B. Details are not described herein again.

It should be noted that, in this embodiment, each photosensitive unit of the circular ring structure has a notch. When the photosensitive modules in this embodiment are combined together, notches of all the photosensitive units are aligned, and jointly form an opening 4011. The opening 4011 is configured to lead out the trace 401 connected to each photosensitive unit. The common electrode line 401f is located on one side of the opening 4011, and the five signal lines are located on the other side of the opening 4011.

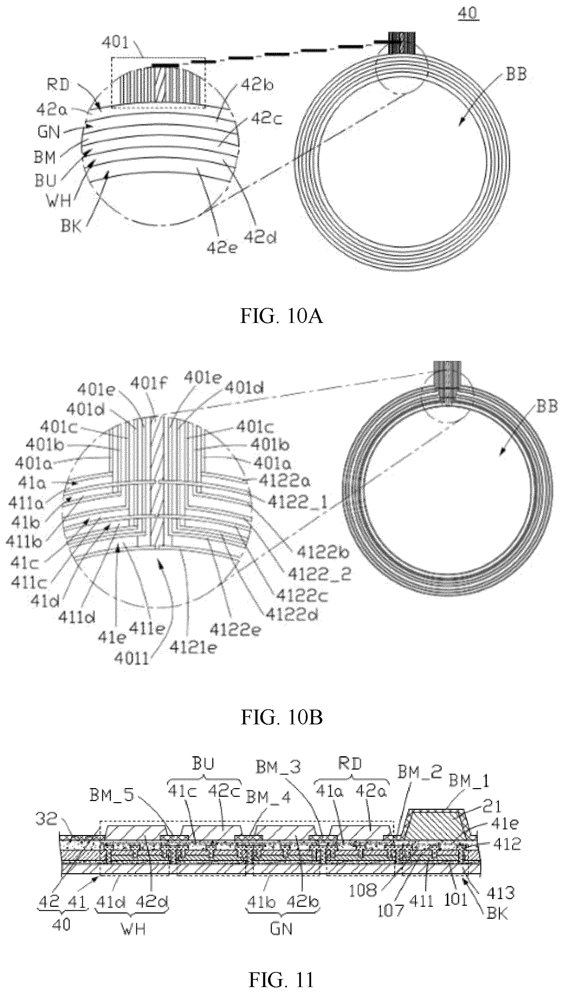

For example, refer to FIG. 10A and FIG. 10B. FIG. 10A is another diagram of the photosensitive component 40 according to an embodiment of this application.

The photosensitive component 40 includes five photosensitive modules: the photosensitive module RD, the photosensitive module GN, the photosensitive module BU, the photosensitive module WH, and the photosensitive module BK. The five photosensitive modules each are of a circular ring structure. The five photosensitive modules are nested with each other.

It may be understood that an arrangement sequence of the five photosensitive modules is not limited herein. For example, the five photosensitive modules are sequentially disposed in a sequence of "RD, GN, BU, WH, and BK" from outside to inside in a radius direction of the circular ring structure.

In a possible implementation, one of the five photosensitive units BK is disposed on an innermost side. The remaining four photosensitive units are divided into two groups, and each group includes two photosensitive units. Second semiconductor layers of the two photosensitive units in each group are in contact with each other in a circumferential direction of a circular ring. The two groups of photosensitive units are spaced from each other, and a black matrix BM is disposed.

For example, FIG. 10B is a diagram of a photosensitive unit of the photosensitive component 40 in FIG. 10A. The photosensitive unit 41a and the photosensitive unit 41b are a first group of photosensitive units, and the photosensitive unit 41c and the photosensitive unit 41d are a second group of photosensitive units. In the first group of photosensitive units, a second semiconductor layer 411a and a second semiconductor layer 411b are in contact with each other in a circumferential direction of a circular ring. In other words, the photosensitive unit 41a and the photosensitive unit 41b share a same second semiconductor layer. Similarly, in the second group of photosensitive units, a second semiconductor layer 411c and a second semiconductor layer 411d are in contact with each other in the circumferential direction of the circular ring.

In this implementation, the photosensitive unit 41e and the second group of photosensitive units are spaced away from each other. In other words, the photosensitive unit 41e and the photosensitive unit 41d are spaced away from each other.

In this embodiment of this application, a common first electrode is included between two photosensitive units in each group of photosensitive units, and each photosensitive unit further includes a second electrode. The photosensitive unit BK includes a first electrode and a second electrode.

For example, the first group of photosensitive units include a common first electrode 4121_1, a common second electrode 4122a, and a common second electrode 4122b. The second group of photosensitive units include a common first electrode 4121_2, a common second electrode 4122a, and a common second electrode 4122b. The photosensitive unit BK includes the first electrode 4121e and the second electrode 4122e.

In this embodiment of this application, the trace 401 includes the trace 401 and includes five signal lines and one common electrode line.

For example, the trace 401 includes the first signal line 401a, the second signal line 401b, the third signal line 401c, the fourth signal line 401d, the fifth signal line 401e, and the common electrode line 401f. The common electrode line 401f is configured to connect the common first electrode in each group of photosensitive units and the first electrode in the photosensitive unit BK. The five signal lines are configured to connect the second electrode in each photosensitive unit. The common electrode line 401f is a negative trace, and the other five signal lines are positive traces. It may be understood that a working principle of the photosensitive component 40 is similar to that in the embodiments described in FIG. 9A and FIG. 9B. Details are not described herein again.

It may be understood that a correspondence between the trace 401 and both the first electrode and the second electrode is different from those in the embodiments described in FIG. 9A and FIG. 9B. Specifically, a first electrode 4121_1, a first electrode 4121_2, and a first electrode 4121 are connected to the common electrode line 401f. The second electrode 4122a is connected to the first signal line 401a, the second electrode 4122b is connected to the second signal line 401b, the second electrode 4122c is connected to the third signal line 401c, the second electrode 4122d is connected to the fourth signal line 401d, and the second electrode 4122e is connected to the fifth signal line 401e.

It should be noted that, in this embodiment, each photosensitive unit of the circular ring structure has a notch. When the photosensitive modules in this embodiment are combined together, notches of all the photosensitive units are aligned, and jointly form an opening 4011. The opening 4011 is configured to lead out the trace 401 connected to each photosensitive unit 41. The common electrode line 401f is located in the middle of the opening 4011. Each of the five signal lines enters the frame region CC from one side of the opening 4011, and leaves the frame region CC from the other side of the opening 4011 after being disposed around the photosensitive unit of the circular ring structure.

In some embodiments, one of the plurality of photosensitive modules of the photosensitive component 40 is disposed below thebarrier wall 21. For example, the photosensitive module BK is disposed below the first barrier wall 21. In this way, an overall area occupied by the photosensitive component 40 can be reduced, so that a width of the frame region CC is reduced, to improve a visual effect of the display panel.

Refer to 11. For example, the photosensitive component 40 is disposed between the middle isolation pillar 32 and the first barrier wall 21. As described in the foregoing embodiment, the photosensitive component 40 includes five ring-shaped photosensitive modules: the photosensitive module RD, the photosensitive module GN, the photosensitive module BU, the photosensitive module WH, and the photosensitive module BK. The photosensitive module BK includes only one photosensitive unit 41e, and the other four photosensitive modules RD, GN, BU, and WH each include one photosensitive unit and one light filtering unit. Specifically, the photosensitive module RD includes the photosensitive unit 41a and the light filtering unit 42a, the photosensitive module GN includes the photosensitive unit 41b and the light filtering unit 42b, the photosensitive module BU includes the photosensitive unit 41c and the light filtering unit 42c, and the photosensitive module WH includes the photosensitive unit 41d and the light filtering unit 42d.

A black matrix BM_1 is covered on a surface of the first barrier wall 21, a black matrix BM_2 is disposed between the first barrier wall 21 and the photosensitive module RD, a black matrix BM_3 is disposed between the photosensitive module RD and the photosensitive module GN, a black matrix BM_4 is disposed between the photosensitive module GN and the photosensitive module BU, and a black matrix BM_5 is disposed between the photosensitive module BU and the photosensitive module WH.

It may be understood that the photosensitive unit 41 is of a layered structure. In this embodiment, the photosensitive unit includes the bottom conductive layer 413, the buffer layer 101, the second semiconductor layer 411, an electrode first dielectric layer 107, and a second dielectric layer 108. The buffer layer 101 covers the bottom conductive layer 413, the second semiconductor layer 411 is formed on the buffer layer 101, the first dielectric layer 107 is formed on surfaces of the buffer layer 101 and the second semiconductor layer 411 and covers the buffer layer 101 and the second semiconductor layer 411, the first electrode layer 412 is formed on the first dielectric layer 107, and the second dielectric layer 108 is formed on the first dielectric layer 107 and the first electrode layer 412, and covers the first dielectric layer 107 and the first electrode layer 412. The first electrode layer 412 is connected to the bottom conductive layer 413 or the second semiconductor layer 411.

Specific structures of the first dielectric layer 107 and the second dielectric layer 108 are not limited in embodiments. For example, the first dielectric layer 107 may include one or more of the gate insulation layer 102 and the interlayer dielectric layer 103. The second dielectric layer 108 may include one or more of the source/drain insulation layer 104, the first passivation layer 105, and the second passivation layer 106, and the second dielectric layer 108 may also include more other structures.

In some embodiments, the first electrode layer 412 includes the first electrode 4121 and the second electrode 4122 (refer to FIG. 3A). Two adjacent photosensitive modules can share one first electrode 4121 or one second electrode 4122. It should be understood that sharing the first electrode 4121 or the second electrode 4122 can reduce traces of the first electrode layer 412, and can further save space of the frame region CC.

For example, two adjacent photosensitive modules can share one first electrode 4121.

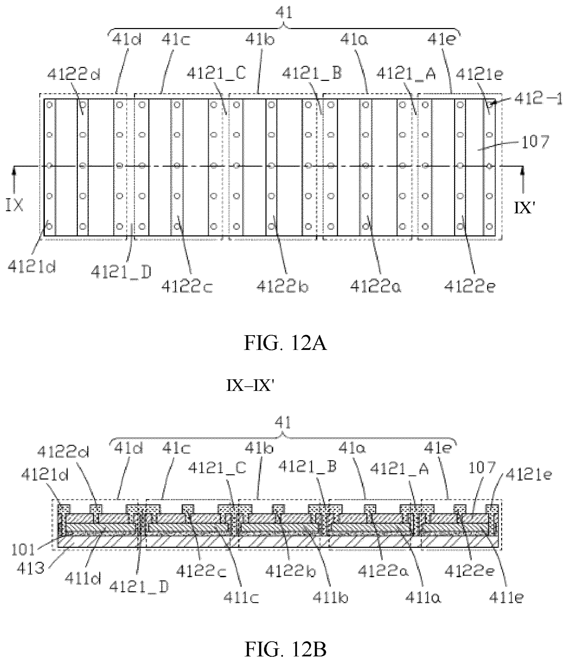

Refer to FIG. 12A and FIG. 12B together. FIG. 12A is a diagram of the photosensitive unit 41 in FIG. 11. FIG. 12B is a sectional view in an IX-IX' direction in FIG. 12A.

The photosensitive unit 41 includes the photosensitive unit 41e, the photosensitive unit 41a, the photosensitive unit 41b, the photosensitive unit 41c, and the photosensitive unit 41d that are sequentially disposed and spaced away from each other from outside to inside. In addition, the four photosensitive units are all formed on the first dielectric layer 107 in a strip shape. Each photosensitive unit includes a strip-shaped first electrode and a strip-shaped second electrode. The first electrode and/or the second electrode are/is connected to the bottom conductive layer 413 or the second semiconductor layer 411 through several conductive through holes.

The bottom conductive layer 413 is included as a whole. In other words, the bottom conductive layer 413 is annular, and is disposed around the opening region BB. A quantity of second semiconductor layers 411 is set based on a quantity of photosensitive modules. In this embodiment, five nested ring-shaped second semiconductor layers 411 are all disposed around the opening region BB. For example, from outside to inside, namely, from a display region to an opening region, the five second semiconductor layers 411 are sequentially the second semiconductor layer 411e, the second semiconductor layer 411a, the second semiconductor layer 411b, the second semiconductor layer 411c, and the second semiconductor layer 411d. It may be understood that interference between signals generated by different photosensitive units can be reduced by disposing the second semiconductor layers separately.

The photosensitive unit includes four common first electrodes: a first electrode 4121_A, a first electrode 4121_B, a first electrode 4121_C, and a first electrode 4121_D. Specifically, the photosensitive unit 41e and the photosensitive unit 41a share the first electrode 4121_A, the photosensitive unit 41a and the photosensitive unit 41b share the first electrode 4121_B, the photosensitive unit 41b and the photosensitive unit 41c share the first electrode 4121_C, and the photosensitive unit 41c and the photosensitive unit 41d share the first electrode 4121_D.

In addition to a part of the first electrode 4121_A, the photosensitive unit 41e further includes a part of the bottom conductive layer 413, the second semiconductor layer 411e, the first electrode 4121e, and the second electrode 4122e. The second electrode 4122e is disposed between the first electrode 4121e and the first electrode 4121_A. The first electrode 4121e is connected to the bottom conductive layer 413 through several conductive through holes 412_1 (the conductive through hole is used as an example, and other conductive through holes are not numbered below). A side that is of the first electrode 4121_A and that is located on the photosensitive unit 41e is connected to the bottom conductive layer 413 through several conductive through holes. The second electrode 4122e is electrically connected to the second semiconductor layer 411e through several conductive through holes.

In addition to a part of the first electrode 4121_A and a part of the first electrode 4121_B, the photosensitive unit 41a further includes a part of the bottom conductive layer 413, the second semiconductor layer 411a, and the second electrode 4122a. The second electrode 4122a is disposed between the first electrode 4121_A and the first electrode 4121_B. A side that is of the first electrode 4121_A and that is located on the photosensitive unit 41a is connected to the bottom conductive layer 413 through several conductive through holes. A side that is of the first electrode 4121_B and that is located on the photosensitive unit 41a is connected to the bottom conductive layer 413 through several conductive through holes. The second electrode 4122a is electrically connected to the second semiconductor layer 411a through several conductive through holes.

In addition to a part of the first electrode 4121_B and a part of the first electrode 4121_C, the photosensitive unit 41b further includes a part of the bottom conductive layer 413, the second semiconductor layer 411b, and the second electrode 4122b. The second electrode 4122b is disposed between the first electrode 4121_B and the first electrode 4121_C. A side that is of the first electrode 4121_B and that is located on the photosensitive unit 41b is connected to the bottom conductive layer 413 through several conductive through holes. A side that is of the first electrode 4121_C and that is located on the photosensitive unit 41b is connected to the bottom conductive layer 413 through several conductive through holes. The second electrode 4122b is electrically connected to the second semiconductor layer 411b through several conductive through holes.

In addition to a part of the first electrode 4121_C and a part of the first electrode 4121_D, the photosensitive unit 41c further includes a part of the bottom conductive layer 413, the second semiconductor layer 411c, and the second electrode 4122c. The second electrode 4122c is disposed between the first electrode 4121_C and the first electrode 4121_D. A side that is of the first electrode 4121_C and that is located on the photosensitive unit 41c is connected to the bottom conductive layer 413 through several conductive through holes. A side that is of the first electrode 4121_D and that is located on the photosensitive unit 41c is connected to the bottom conductive layer 413 through several conductive through holes. The second electrode 4122c is electrically connected to the second semiconductor layer 411c through several conductive through holes.

In addition to a part of the first electrode 4121_D, the photosensitive unit 41d further includes a part of the bottom conductive layer 413, the second semiconductor layer 411d, the first electrode 4121d, and the second electrode 4122d. The second electrode 4122d is disposed between the first electrode 4121_D and the first electrode 4121d. A side that is of the first electrode 4121_D and that is located on the photosensitive unit 41d is connected to the bottom conductive layer 413 through several conductive through holes. The first electrode 4121d is connected to the bottom conductive layer 413 through several conductive through holes. The second electrode 4122d is electrically connected to the second semiconductor layer 411d through several conductive through holes.

In this embodiment, each photosensitive unit includes two first electrodes (including a first electrode shared with an adjacent photosensitive unit and a dedicated first electrode), and one second electrode. For example, the first electrode provides a signal input, and the second electrode is configured to transmit the signal.

It may be understood that, in each photosensitive unit, left and right first electrodes are disposed to provide signal inflow, and one second electrode is disposed to provide signal outflow, so that a voltage or current signal between the first electrode and the second electrode can be greatly increased. For each photosensitive module, after ambient light passes through a light filtering unit corresponding to the photosensitive module, remaining light is irradiated to a corresponding photosensitive unit. Under irradiation of light, a photocurrent is formed between the first electrode and the second electrode. Each photosensitive module transfers, through a trace connected to the second electrode, the current or voltage signal generated between the first electrode and the second electrode, for example, transfers the current or voltage signal to the driver chip.

In some embodiments, every two photosensitive modules form one group, and one first electrode 4121 or one second electrode 4122 can be shared in a same group. It should be understood that sharing the first electrode 4121 or the second electrode 4122 can reduce traces of the first electrode layer 412, and can further save space of the frame region CC.

For example, two adjacent photosensitive modules can share one first electrode 4121.

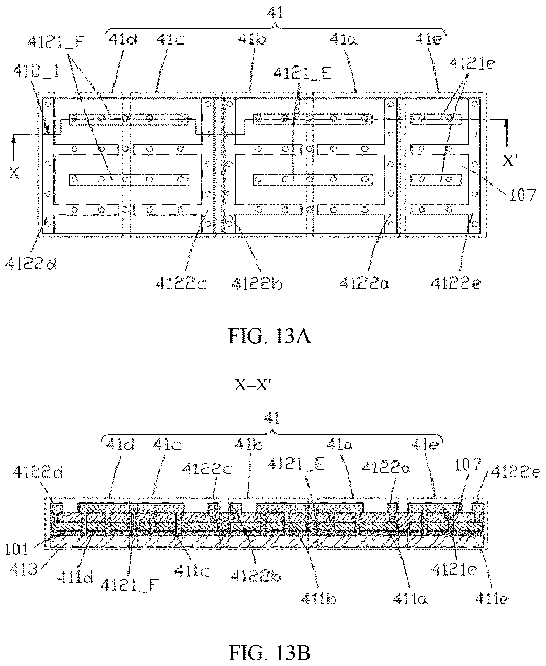

Refer to FIG. 13A and FIG. 13B together. FIG. 13A is another diagram of the photosensitive unit 41 in FIG. 11. FIG. 13B is a sectional view in an X-X' direction in FIG. 12A.

Position arrangement of the photosensitive units (41e, 41a, 41b, 41c, and 41d), a structure of the bottom conductive layer 413, and structures of the second semiconductor layers (411e, 411a, 411b, 411c and 411d) are the same as those in the embodiments in FIG. 12A and FIG. 12B. Details are not described herein again. A difference lies only in that a specific structure in each photosensitive unit, especially forms of the first electrode 4121 and the second electrode 4122, are different.

In this embodiment, each photosensitive unit includes a first electrode that is disposed in a radial direction, namely, a radius direction of a circle enclosed by the frame region CC. The first electrode is electrically connected to the bottom conductive layer 413 through a conductive through hole. A second electrode of each photosensitive unit includes a main body part and an extension part, the main body part of the second electrode is disposed around the frame region, and the extension part of the second electrode is disposed perpendicular to the main body part. The extension part and the first electrode are disposed in parallel and spaced away from each other.

The photosensitive unit includes two common first electrodes: a first electrode 4121_E and a first electrode 4121_F. Specifically, the photosensitive unit 41a and the photosensitive unit 41b share one first electrode 4121_E, and the photosensitive unit 41c and the photosensitive unit 41d share one first electrode 4121_F.

The photosensitive unit 41e includes a part of the bottom conductive layer 413, the second semiconductor layer 411e, the first electrode 4121e, and the second electrode 4122e. The first electrode 4121e is electrically connected to the bottom conductive layer 413 through a conductive through hole. The second electrode 4122e is electrically connected to the second semiconductor layer 411a through a conductive through hole.

In addition to a part of the first electrode 4121_E, the photosensitive unit 41a further includes a part of the bottom conductive layer 413, the second semiconductor layer 411a, and the second electrode 4122a. A part that is of the first electrode 4121_E and that is located in the photosensitive unit 41a is electrically connected to the bottom conductive layer 413 through a conductive through hole. The second electrode 4122a is connected to the second semiconductor layer 411a through a conductive through hole.

In addition to a part of the first electrode 4121_E, the photosensitive unit 41b further includes a part of the bottom conductive layer 413, the second semiconductor layer 411b, and the second electrode 4122b. A part that is of the first electrode 4121_E and that is located in the photosensitive unit 41b is electrically connected to the bottom conductive layer 413 through a conductive through hole. The second electrode 4122b is connected to the second semiconductor layer 411b through a conductive through hole.

In addition to a part of the first electrode 4121_F, the photosensitive unit 41c further includes a part of the bottom conductive layer 413, the second semiconductor layer 411c, and the second electrode 4122c. A part that is of the first electrode 4121_F and that is located in the photosensitive unit 41c is electrically connected to the bottom conductive layer 413 through a conductive through hole. The second electrode 4122c is connected to the second semiconductor layer 411c through a conductive through hole.

In addition to a part of the first electrode 4121_F, the photosensitive unit 41d further includes a part of the bottom conductive layer 413, the second semiconductor layer 411d, and the second electrode 4122d. A part that is of the first electrode 4121_F and that is located in the photosensitive unit 41d is electrically connected to the bottom conductive layer 413 through a conductive through hole. The second electrode 4122d is connected to the second semiconductor layer 411d through a conductive through hole.

In this embodiment, each photosensitive unit includes a plurality of first electrodes, and the plurality of first electrodes are inserted between extension parts of second electrodes. In this way, more photocurrents can be formed between the first electrode and the second electrode that are adjacent to each other when light is irradiated, to improve a photosensitive effect of a display surface.

In some embodiments, every two photosensitive modules form one group, and one first electrode 4121 (or one second electrode 4122) and one bottom metal layer can be shared in a same group. It should be understood that sharing the first electrode 4121 or the second electrode 4122 and the bottom metal layer can reduce traces of the first electrode layer 412, and can further reduce space of the frame region CC.

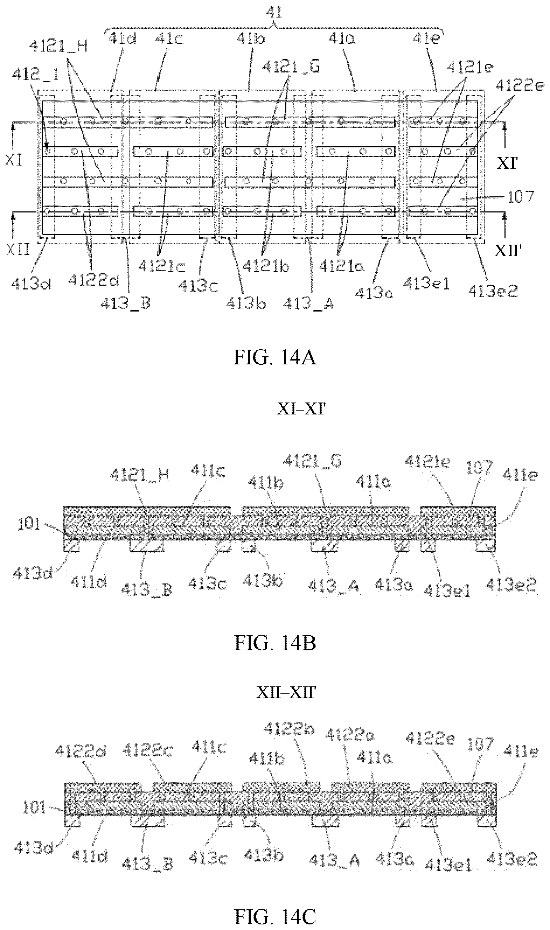

Refer to FIG. 14A, FIG. 14B, and FIG. 14C together. FIG. 14A is another diagram of the photosensitive unit 41 in FIG. 11. FIG. 14B is a sectional view in an XI-XI' direction in FIG. 14A. FIG. 14C is a sectional view in an XII-XII' direction in FIG. 14A.

Position arrangement of the photosensitive units (41e, 41a, 41b, 41c, and 41d) and structures of the second semiconductor layers (411e, 411a, 411b, 411c and 411d) are the same as those in the embodiments in FIG. 12A and FIG. 12B. Details are not described herein again. A difference lies only in that a specific structure in each photosensitive unit, especially a form of the bottom conductive layer 413, and forms of the first electrode 4121 and the second electrode 4122 are different.

In this embodiment, the first electrode and the second electrode are separately traced through the bottom metal layer 413 below. The photosensitive unit includes two shared bottom metal layers: a bottom metal layer 413_A and a bottom metal layer 413_B. Specifically, the photosensitive unit 41a and the photosensitive unit 41b share one bottom metal layer 413_A, and the photosensitive unit 41c and the photosensitive unit 41d share one bottom metal layer 413_B.

The photosensitive unit further includes two shared first electrodes: a first electrode 4121_G and a first electrode 4121_H. Specifically, the photosensitive unit 41a and the photosensitive unit 41b share one first electrode 4121_G, and the photosensitive unit 41c and the photosensitive unit 41d share one first electrode 4121_H.

The photosensitive unit 41e includes the first electrode 4121e, the second electrode 4122e, the second semiconductor layer 411e, a bottom conductive layer 413e1, and a bottom conductive layer 413e2. The first electrode 4121e is electrically connected to the bottom conductive layer 413e1 through a conductive through hole. The second electrode 4122e is electrically connected to the bottom conductive layer 413e2 through a conductive through hole.

The photosensitive unit 41a includes a part of the first electrode 4121_G, the second electrode 4122a, the second semiconductor layer 411a, a part of the bottom metal layer 413_A, and the bottom metal layer 413a. A part that is of the first electrode 4121_G and that is located in the photosensitive unit 41a is electrically connected to the bottom conductive layer 413_Athrough a conductive through hole. The second electrode 4122a is electrically connected to the bottom conductive layer 413a through a conductive through hole.

The photosensitive unit 41b includes a part of the first electrode 4121_G, the second electrode 4122b, the second semiconductor layer 411b, a part of the bottom metal layer 413_A, and a bottom metal layer 413b. A part that is of the first electrode 4121_G and that is located in the photosensitive unit 41b is electrically connected to the bottom conductive layer 413_A through a conductive through hole. The second electrode 4122b is electrically connected to the bottom conductive layer 413b through a conductive through hole.

The photosensitive unit 41c includes a part of the first electrode 4121_H, the second electrode 4122c, the second semiconductor layer 411c, a part of the bottom metal layer 413_B, and a bottom metal layer 413c. A part that is of the first electrode 4121_H and that is located in the photosensitive unit 41c is electrically connected to the bottom conductive layer 413_B through a conductive through hole. The second electrode 4122c is electrically connected to the bottom conductive layer 413c through a conductive through hole.

The photosensitive unit 41d includes a part of the first electrode 4121_H, the second electrode 4122d, the second semiconductor layer 411d, a part of the bottom metal layer 413_B, and the bottom metal layer 413d. A part that is of the first electrode 4121_H and that is located in the photosensitive unit 41d is electrically connected to the bottom conductive layer 413_B through a conductive through hole. The second electrode 4122d is electrically connected to the bottom conductive layer 413d through a conductive through hole.

In this embodiment, each photosensitive unit includes a plurality of first electrodes and a plurality of second electrodes, and the first electrodes and the second electrodes are disposed in parallel and are spaced away from each other. In this way, more photocurrents can be formed between the first electrode and the second electrode that are adjacent to each other when light is irradiated, to improve a photosensitive effect of a display panel. In this embodiment, the photosensitive modules can be arranged in different manners according to different requirements.

In an implementation, the photosensitive component 40 includes four photosensitive modules. The four photosensitive modules each are of a circular ring structure. The four photosensitive modules are nested with each other.

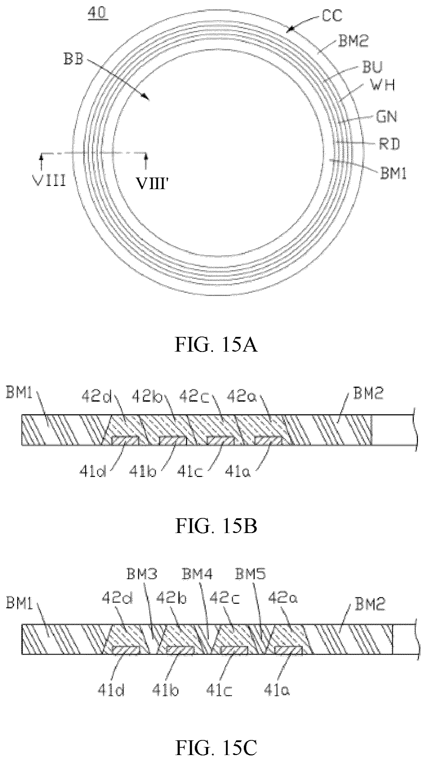

For example, FIG. 15A is another diagram of the photosensitive component 40 according to an embodiment of this application. The photosensitive component 40 includes four photosensitive modules (RD, GN, BU, and WH). The four photosensitive modules each are of a circular ring structure, and are nested with each other. The four photosensitive modules jointly form a circular ring structure.

It may be understood that an arrangement sequence of the four photosensitive modules is not limited herein. For example, the four photosensitive modules are sequentially disposed from inside to outside in a sequence of "RD, GN, BU, and WH" in a radius direction of the circular ring structure.

In this implementation, black matrices are disposed on two sides of the circular ring structure jointly formed by the four photosensitive modules. FIG. 15B is a cross-sectional view of the photosensitive unit in FIG. 15A in a VIII-VIII' direction. For example, a black matrix BM1 and a black matrix BM2 are respectively disposed on an inner side and an outer side of the circular ring structure jointly formed by the four photosensitive modules.

In a possible case, a black matrix is also disposed between adjacent photosensitive modules. Refer to FIG. 15C. For example, a black matrix BM3 is disposed between the photosensitive module WH and the photosensitive module GN, a black matrix BM4 is disposed between the photosensitive module GN and the photosensitive module BU, and a black matrix BM5 is disposed between the photosensitive module BU and the photosensitive module RD.

In an implementation, the photosensitive component 40 includes two photosensitive modules. The two photosensitive modules each are of a circular ring structure. The two photosensitive modules are nested with each other.

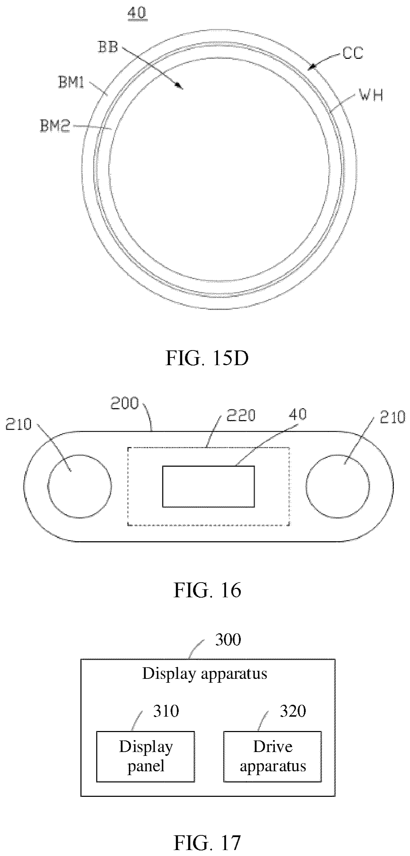

For example, FIG. 15D is another diagram of the photosensitive component 40 according to an embodiment of this application. The photosensitive component 40 includes the photosensitive module WH. A black matrix BM1 and a black matrix BM2 are respectively disposed on an outer side and an inner side of the photosensitive module WH.

In this implementation, a photosensitive module BK configured to provide a reference value of light intensity is disposed in one of a region in which the black matrix BM1 and the black matrix BM2 are located. For example, the photosensitive module BK may be disposed on an inner edge of a photosensitive module WH of a circular ring structure. For another example, the photosensitive module BK may be disposed on an outer edge of a photosensitive module WH of a circular ring structure.

In an embodiment, the display panel includes a functional region and a display region. The functional region includes two opening regions. The photosensitive component can be disposed at a position between the two opening regions.

For example, FIG. 16 is a diagram of a functional region 200 of a display panel according to an embodiment of this application.

As shown in FIG. 16, the functional region 200 includes two opening regions 210. A blank region 220 is disposed between the two opening regions 210. The photosensitive component 40 can be disposed on any position in the blank region 220.

It may be understood that a difference between the photosensitive component 40 in this embodiment and the photosensitive component 40 in the foregoing embodiments lies only in that: The photosensitive component 40 in the foregoing embodiments is disposed in the frame region between the opening region and the display region, and the photosensitive component 40 in this embodiment is disposed between the two opening regions 210. Therefore, for a position relationship between the photosensitive component 40 and the driving thin film transistor (not shown in the figure), refer to FIG. 3A to FIG. 3D. Same parts are not described herein again.

In this embodiment, a shape of the photosensitive component 40 is not limited. For example, the shape may be a square, a circle, or a circular ring.

In a possible implementation, the display panel includes a display region and two opening regions. The display panel includes a substrate, a driving thin film transistor, and a photosensitive component. The driving thin film transistor is formed in the display region, and the driving thin film transistor is configured to drive a light emitting component of the display panel. The photosensitive component is formed between the two opening regions, and the photosensitive component is configured to detect ambient light. Both the photosensitive component and the driving thin film transistor are disposed on the substrate.

Refer to FIG. 17. An embodiment of this application further provides a display apparatus 300. The display apparatus 300 includes a display panel 310 and a drive circuit 320. It may be understood that the display panel 310 may be a display panel a in any one of the foregoing embodiments. The drive circuit 320 is connected to the display panel 310, and is configured to drive the display panel to perform displaying. The drive circuit 320 is further configured to: provide a working voltage to the photosensitive component 40, and receive a signal transmitted by the photosensitive component 40.

In this embodiment of this application, both the photosensitive component 40 and the driving thin film transistor 60 are disposed on a substrate of the display panel 100. In other words, the photosensitive component 40 is integrated into the display panel 100, so that attenuation of light passing through the display panel 100 can be reduced, and a light sensing capability of the photosensitive component 40 is improved. The photosensitive component 40 is disposed in a frame region around an opening region of the display panel 100, or the photosensitive component 40 is disposed between two opening regions, so that a display area that is of the display panel 100 and that is occupied by the photosensitive component 40 can be reduced, and the display area is maximized.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display panel, wherein the display panel comprises a display region, an opening region, and a frame region, and the frame region is disposed around the opening region and is located between the display region and the opening region;
the display panel comprises:
a substrate;
a driving thin film transistor, formed in the display region, wherein the driving thin film transistor is configured to drive a light emitting component of the display panel; and
a photosensitive component, formed in the frame region, wherein the photosensitive component is configured to detect ambient light; and
both the photosensitive component and the driving thin film transistor are disposed on the substrate.

2. The display panel according to claim 1, wherein the display panel further comprises a buffer layer, and the buffer layer is formed on the substrate;
the driving thin film transistor comprises a first semiconductor layer and a source/drain layer, the first semiconductor layer is formed on the buffer layer, and the source/drain layer is formed on a side that is of the first semiconductor layer and that is away from the substrate; and
the photosensitive unit comprises a second semiconductor layer and a first electrode layer, the second semiconductor layer is formed on the buffer layer, and the first electrode layer is formed on a side that is of the second semiconductor layer and that is away from the substrate.

3. The display panel according to claim 2, wherein the display panel further comprises a top conductive layer, the top conductive layer is formed on a side that is of the first electrode layer and the source/drain layer and that is away from the substrate, and the top conductive layer is used for tracing of the first electrode layer and the source/drain layer.

4. The display panel according to claim 2, wherein the display panel further comprises a bottom conductive layer, the bottom conductive layer is formed on a side that is of the first semiconductor layer and the second semiconductor layer and that is close to the substrate, and the bottom conductive layer is used for tracing of the first electrode layer.

5. The display panel according to any one of claims 1 to 4, wherein the display panel comprises scanning lines and data lines that are vertically disposed in a cross manner;
at least a part of the scanning lines are disconnected at a same column of pixel units in a direction perpendicular to the scanning lines, and disconnection points of several scanning lines jointly form a tracing channel; and
a trace of the photosensitive unit passes through the tracing channel and is connected from the frame region to an end part of the display panel.

6. The display panel according to any one of claims 1 to 5, wherein the photosensitive component comprises at least two photosensitive modules, and the at least two photosensitive modules are disposed around the opening region.

7. The display panel according to claim 6, wherein the at least two photosensitive modules are of a sector ring structure, and the photosensitive modules of the sector ring structure are connected end to end, and jointly form a circular ring structure through enclosing.

8. The display panel according to claim 6, wherein each photosensitive module is of a circular ring structure, and the at least two photosensitive modules are nested.

9. The display panel according to claim 2, wherein the display panel comprises a baarrier wall and an isolation pillar, and the barrier wall and the isolation pillar are formed on the substrate;
the barrier wall comprises a first barrier wall;
the isolation pillar comprises an inner isolation pillar and a middle isolation pillar, the inner isolation pillar is located on a side that is of the first barrier wall and that is close to the display region, and the middle isolation pillar is located on a side that is of the first barrier wall and that is close to the opening region; and
the photosensitive component is disposed between the first barrier wall and the inner isolation pillar, or the photosensitive component is disposed between the first barrier wall and the middle isolation pillar.

10. The display panel according to claim 9, wherein the barrier wall further comprises a second barrier wall, and the isolation pillar further comprises an outer isolation pillar;
the second barrier wall is located on a side that is of the middle isolation pillar and that is close to the opening region;
the outer isolation pillar is located on a side that is of the second barrier wall and that is close to the opening region; and
the photosensitive component is disposed between the first barrier wall and the inner isolation pillar, or the photosensitive component is disposed between the first barrier wall and the middle isolation pillar, or the photosensitive component is disposed between the second barrier wall and the middle isolation pillar.

11. The display panel according to claim 9, wherein the photosensitive component comprises at least two photosensitive modules, each photosensitive module is of a circular ring structure, the at least two photosensitive modules are nested, and one of the at least two photosensitive modules is disposed below the first barrier wall.

12. The display panel according to claim 1, wherein the display panel comprises:
a first inorganic layer, formed in the display region and the frame region, wherein the first inorganic layer covers the driving thin film transistor and the photosensitive unit;
an organic layer, formed in the display region and at least a part of the frame region; and
a second inorganic layer, formed in the display region and the frame region, wherein the second inorganic layer is formed on a surface of the first inorganic layer or the organic layer.

13. The display panel according to claim 1, wherein the display panel further comprises an amplification unit, and the amplification unit is connected to the photosensitive component, and is configured to amplify a signal measured by the photosensitive component.

14. A display panel, wherein the display panel comprises a display region and two opening regions;
the display panel comprises:
a substrate;
a driving thin film transistor, formed in the display region, wherein the driving thin film transistor is configured to drive a light emitting component of the display panel; and
a photosensitive component, formed between the two opening regions, wherein the photosensitive component is configured to detect ambient light; and
both the photosensitive component and the driving thin film transistor are disposed on the substrate.

15. A display apparatus, wherein the display apparatus comprises:
the display panel according to any one of claims 1 to 14; and
a drive circuit, configured to: drive the display panel to perform displaying, provide a working voltage for the photosensitive component, and receive a signal transmitted by the photosensitive component.
